# EUROPEAN PATENT APPLICATION

(11) **EP 4 380 341 A1**
(43) Date of publication of application: **05.06.2024**
(21) Application number: 23212213.5
(22) Date of filing: 27.11.2023
(51) Int. Cl.: H10K 59/124, H10K 59/131, H10K 77/10

(54) **DISPLAY APPARATUS**

(30) Priority: 29.11.2022 KR 20220163415
(71) Applicant: Samsung Display Co., Ltd., Yongin-si, Gyeonggi-do 17113 (KR)
(72) Inventor: KIM, Yanghee, 17113 Yongin-si, Gyeonggi-do, (KR); KIM, Jaewon, 17113 Yongin-si, Gyeonggi-do, (KR); PARK, Hyungjun, 17113 Yongin-si, Gyeonggi-do, (KR); JEONG, Jintae, 17113 Yongin-si, Gyeonggi-do (KR)
(74) Representative: Gulde & Partner

(57) **Abstract**

A display apparatus includes: a substrate including a plurality of sub-pixel areas; an inorganic insulating layer defining a groove between two adjacent sub-pixel areas from among the plurality of sub-pixel areas in a plan view; an organic material layer filled in the groove; and a wiring line disposed on the organic material layer and passing through the two adjacent sub-pixel areas, where the organic material layer includes a first portion overlapping the groove in the plan view and a second portion extending from the first portion in an extension direction of the wiring line.

## Description

### BACKGROUND

### 1. Field

One or more embodiments relate to a display apparatus.

### 2. Description of the Related Art

The usage of a display apparatus has diversified. In addition, as the display apparatus has become thinner and lighter, their range of use has been gradually extended. Research has been conducted to implement flexible display apparatuses, such as foldable display apparatuses or rollable display apparatuses, in addition to flat panel display apparatuses.

### SUMMARY

One or more embodiments include a display apparatus that is robust against external impacts and has improved reliability. However, these embodiments are just examples, and the scope of the disclosure is not limited thereby.

Additional aspects will be set forth in part in the description which follows and, in part, will be apparent from the description, or may be learned by practice of the presented embodiments of the disclosure. According to one or more embodiments, a display apparatus includes a substrate including a plurality of sub-pixel areas, an inorganic insulating layer defining a groove between two adjacent sub-pixel areas among the plurality of sub-pixel areas in a plan view, an organic material layer filled in the groove, and a wiring line disposed on the organic material layer and passing through the two adjacent sub-pixel areas, the wiring line extending in a direction crossing the groove, where the organic material layer includes a first portion overlapping the groove in the plan view and a second portion extending from the first portion in an extension direction of the wiring line.

The second portion of the organic material layer may be disposed under the wiring line.

A width of the second portion of the organic material layer may be greater than a width of the wiring line.

A vertical distance from an upper surface of the substrate to an upper surface of the organic material layer may be greater than a vertical distance from the upper surface of the substrate to an upper surface of the inorganic insulating layer. The vertical distance may a distance measured in a Z-direction in the drawings below. The vertical distance from the upper surface of the substrate to an upper surface of the inorganic insulating layer may be measured on a surface of the inorganic insulating layer where the groove is not defined.

The wiring line may be in direct contact with the organic material layer.

The groove may surround at least some of the plurality of sub-pixel areas in the plan view.

The groove may surround each of the plurality of sub-pixel areas in the plan view.

The display apparatus may further include a first thin-film transistor disposed in each of the plurality of sub-pixel areas and including a first semiconductor layer and a first gate electrode overlapping a channel region of the first semiconductor layer, and an electrode overlapping and electrically connected to one of a source region and a drain region of the first semiconductor layer in the plan view.

The display apparatus may further include a second thin-film transistor disposed in each of the plurality of sub-pixel areas and including a second semiconductor layer and a second gate electrode overlapping the second semiconductor layer, where the first semiconductor layer of the first thin-film transistor may include a silicon semiconductor material, and the second semiconductor layer of the second thin-film transistor may include an oxide semiconductor material.

The wiring line may include a same material as a material of the electrode.

The display apparatus may include a display area including the plurality of sub-pixel areas, where the display area may be foldable or rollable.

According to one or more embodiments, a display apparatus includes a substrate including a first sub-pixel area and a second sub-pixel area adjacent to each other, a first thin-film transistor disposed in the first sub-pixel area and including a first semiconductor layer and a first gate electrode, a second thin-film transistor disposed in the second sub-pixel area and including a second semiconductor layer and a second gate electrode, an inorganic insulating layer defining a groove between the first sub-pixel area and the second sub-pixel area in a plan view, an organic material layer filled in the groove, and a wiring line disposed on the organic material layer and passing through the first sub-pixel area and the second sub-pixel area, where the organic material layer includes a first portion overlapping the groove in the plan view and a second portion extending from the first portion in an extension direction of the wiring line.

The second thin-film transistor may be symmetrical with the first thin-film transistor.

The second portion of the organic material layer may be disposed under the wiring line.

A width of the second portion of the organic material layer may be greater than a width of the wiring line.

A vertical distance from an upper surface of the substrate to an upper surface of the organic material layer may be greater than a vertical distance from the upper surface of the substrate to an upper surface of the inorganic insulating layer.

The wiring line may be in direct contact with the organic material layer.

The groove may surround at least one of the first sub-pixel area and the second sub-pixel area in the plan view.

The display apparatus may further include a third thin-film transistor disposed in the first sub-pixel area and including a third semiconductor layer, and a fourth thin-film transistor disposed in the second sub-pixel area and including a fourth semiconductor layer, where the first semiconductor layer and the second semiconductor layer may include a silicon semiconductor material, and the third semiconductor layer and the fourth semiconductor layer may include an oxide semiconductor material.

The display apparatus may further include an electrode overlapping and electrically connected to one of a source region and a drain region of the first semiconductor layer in the plan view, where the wiring line may include a same material as a material of the electrode.

### BRIEF DESCRIPTION OF THE DRAWINGS

The above and other aspects, features, and advantages of certain embodiments of the disclosure will be more apparent from the following description taken in conjunction with the accompanying drawings, in which:
FIGS. 1A and 1B are schematic plan views of a display apparatus before being folded, according to an embodiment;
FIGS. 2A and 2B are schematic cross-sectional views of a display apparatus in a folded state, according to an embodiment;
FIGS. 3A and 3B are equivalent circuit diagrams of a sub-pixel included in a display apparatus according to an embodiment;
FIG. 4 is a cross-sectional view illustrating a structure of a display element according to an embodiment;
FIGS. 5A to 5D are cross-sectional views illustrating structures of a display element according to an embodiment;
FIG. 6A is a cross-sectional view showing an example of an organic light-emitting diode of FIG. 5C;
FIG. 6B is a cross-sectional view showing an example of an organic light-emitting diode of FIG. 5D;
FIG. 7 is a cross-sectional view illustrating a structure of a sub-pixel of a display apparatus according to an embodiment;
FIGS. 8A and 8B are schematic plan views of a display apparatus according to an embodiment;
FIG. 9 is a cross-sectional view of the display apparatus taken along lines A-A' and B-B' in FIG. 8A;
FIG. 10 is a schematic plan view illustrating positions of components arranged in two adjacent sub-pixel areas of a display apparatus according to an embodiment;
FIGS. 11A to 11H are plan views according to a process of forming components arranged in two adjacent sub-pixel areas of a display apparatus according to an embodiment;
FIG. 12 is a view illustrating some components of a display apparatus according to an embodiment and is a plan view of a portion X of FIG. 8A;
FIG. 13 is a schematic cross-sectional view of a portion of a display apparatus according to an embodiment;
FIG. 14 is a schematic perspective view of a portion of a display apparatus according to a comparative example; and
FIG. 15 is a schematic perspective view of a portion of a display apparatus according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof. Because the disclosure may have diverse modified embodiments, preferred embodiments are illustrated in the drawings and are described in the detailed description. An effect and a characteristic of the disclosure, and a method of accomplishing these will be apparent when referring to embodiments described with reference to the drawings. The disclosure may, however, be embodied in many different forms and should not be construed as limited to the embodiments set forth herein. While such terms as "first," "second," etc., may be used to describe various components, such components are not be limited to the above terms. The above terms are used only to distinguish one component from another.

An expression used in the singular encompasses the expression of the plural, unless it has a clearly different meaning in the context.

In the present specification, it is to be understood that the terms "including," "having," and "comprising" are intended to indicate the existence of the features, numbers, steps, actions, components, parts, or combinations thereof disclosed in the specification, and are not intended to preclude the possibility that one or more other features, numbers, steps, actions, components, parts, or combinations thereof may exist or may be added.

It will be understood that when a layer, region, or component is referred to as being "formed on," another layer, region, or component, it may be directly or indirectly formed on the other layer, region, or component. That is, for example, intervening layers, regions, or components may be present. Sizes of elements in the drawings may be exaggerated for convenience of explanation. In other words, because sizes and thicknesses of components in the drawings are arbitrarily illustrated for convenience of explanation, the following embodiments are not limited thereto.

In the specification, the phrase "A and/or B" denotes A, B, or A and B. In addition, the phrase "at least one of A and B" denotes A, B, or A and B.

As used herein, when a wiring is referred to as "extending in a first direction or a second direction," it means that the wiring not only extends in a straight line shape but also extends in a zigzag or in a curve in the first direction or the second direction.

As used herein, "in a plan view" means that an objective portion is viewed from above (i.e., view in a z direction), and "in a cross-sectional view" means that a cross-section of an objective portion taken vertically is viewed from a lateral side. As used herein, "overlapping" includes overlapping "in a plan view" and "in a cross-sectional view."

Hereinafter, embodiments of the disclosure are described in detail with reference to the accompanying drawings. When description is made with reference to the drawings, like reference numerals are used for like or corresponding elements.

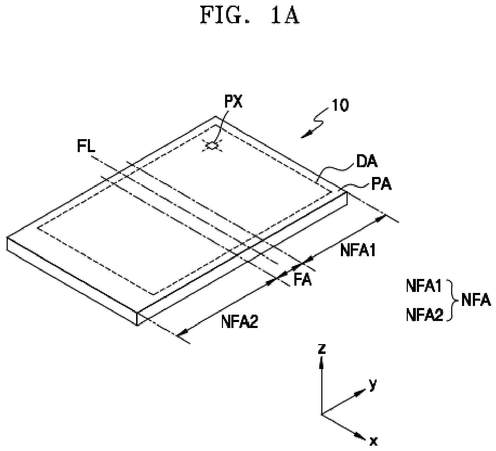

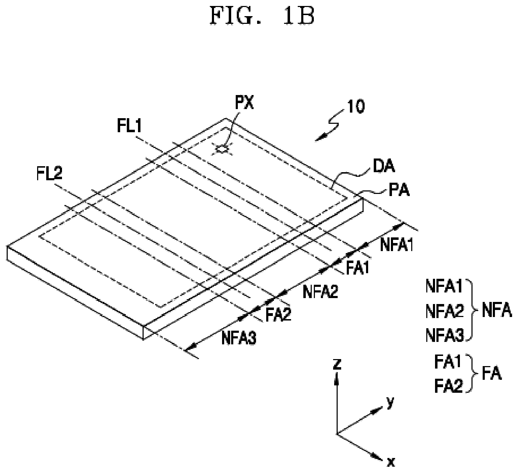

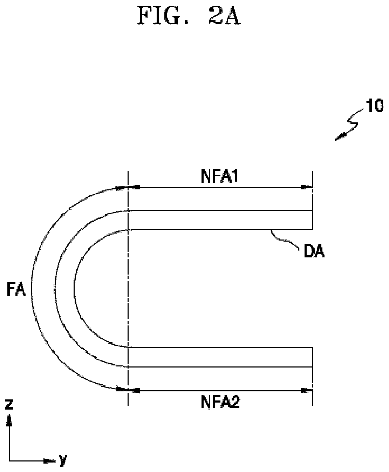

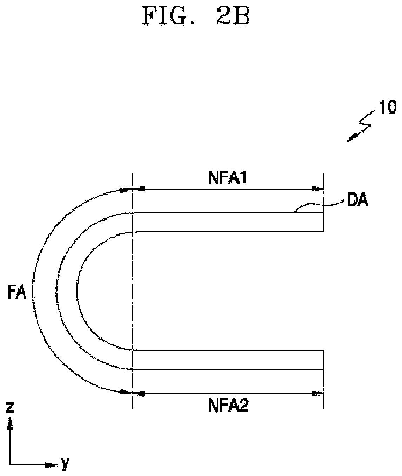

FIGS. 1A and 1B are schematic views of a display apparatus before being folded, according to an embodiment. FIGS. 2A and 2B are schematic cross-sectional views of the display apparatus in a folded state, according to an embodiment.

Referring to FIGS. 1A to 2B, the display apparatus may include a display panel 10. The display panel 10 may include a display area DA and a peripheral area PA positioned outside the display area DA. Although it is illustrated in FIG. 1 that the display area DA has a substantially rectangular shape, the disclosure is not limited thereto. The display area DA may have various shapes, such as a circle, an ellipse, and a polygon.

The display area DA may be an area where an image is displayed, and a plurality of sub-pixels PX may be arranged in the display area DA. Each sub-pixel PX may include a display element, such as an organic light-emitting diode. Each sub-pixel PX may emit, for example, red, green, blue, or white light. The display area DA may provide a certain image by using light emitted from the sub-pixels PX. The peripheral area PA may be an area where no sub-pixels PX are arranged and no images are provided. In the peripheral area PA, a printed circuit board including power supply lines and driving circuits for driving the sub-pixels PX or a terminal portion to which a driver integrated circuit ("IC") is connected may be arranged.

At least a portion of the display panel 10 may be flexible, and the flexible portion may be folded. In other words, the display panel 10 may include a foldable area FA that is flexible and foldable, and a non-foldable area NFA that is provided on at least one side of the foldable area and not folded. In this case, according to an embodiment, an area that is not folded is referred to as a non-foldable area, but this is for convenience of description. The term "non-foldable" includes not only a case in which the area is hard due to no flexibility, but also a case in which the area is flexible but less flexible than the foldable area FA, and a case in which the area is flexible but not folded. The display panel 10 may display an image in the display area DA of the foldable area FA and the non-foldable area NFA.

For convenience of description, FIG. 1A illustrates that two non-foldable areas NFA1 and NFA2 have similar areas and one foldable area FA is between the two non-foldable areas NFA1 and NFA2, but the disclosure is not limited thereto. In another embodiment, for example, the non-foldable areas NFA1 and NFA2 may have different areas. Also, as shown in FIG. 1B, one or more foldable areas FA may be provided. In this case, a plurality of non-foldable areas NFA1, NFA2, and NFA3 may be provided to be apart from each other with foldable areas FA1 and FA2 therebetween. The foldable areas FA, FA1, and FA2 may be folded based on folding lines FL, FL1, and FL2, respectively, and a plurality of folding lines FL, FL1, and FL2 may be provided. The folding lines FL, FL1, and FL2 may be provided in the foldable areas FA, FA1, and FA2 in an extension direction (e.g., an x direction) of the foldable areas FA, FA1, and FA2, and thus, the display panel 10 may be folded in the foldable areas FA, FA1, and FA2.

FIGS. 1A and 1B illustrate that the folding lines FL, FL1, and FL2 pass through the centers of the foldable areas FA, FA1, and FA2, respectively, and the foldable areas FA, FA1, and FA2 are axisymmetric with respect to the folding lines FL, FL1, and FL2, but are not limited thereto. In other words, the folding lines FL, FL1, and FL2 may be asymmetrically provided within the foldable areas FA, FA1, and FA2 in another embodiment.

In some embodiments, the display panel 10 may entirely correspond to a foldable area. In an embodiment, for example, in the case of a display apparatus that rolls like a scroll, the display panel 10 may entirely correspond to a foldable area.

As shown in FIGS. 1A and 1B, the display panel 10 may be unfolded flat as a whole. In an embodiment, the display panel 10 may be folded so that portions of the display area DA face each other with respect to the folding line FL, as shown in FIG. 2A. In another embodiment, the display panel 10 may be folded so that the display area DA faces the outside with respect to the folding line FL, as shown in FIG. 2B. In this case, the term "folded" means that the shape is not fixed, but an original shape may be transformed into another shape, and includes being folded, curved, or rolled along one or more specific lines, i.e., folding lines FL. Although FIGS. 2A and 2B illustrate a state in which surfaces of the two non-foldable areas NFA1 and NFA2 are positioned parallel to each other and folded to face each other, the disclosure is not limited thereto. In some embodiments, surfaces of the two non-foldable areas NFA1 and NFA2 may be folded at a certain angle (e.g., an acute angle, a right angle, or an obtuse angle) with the foldable area FA therebetween.

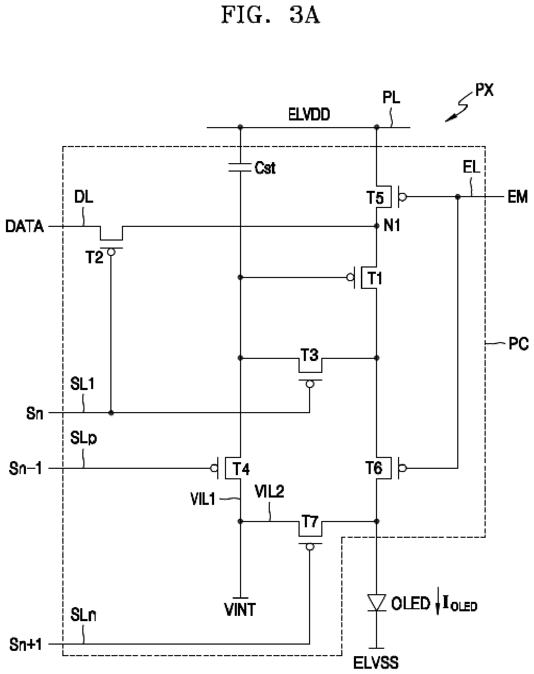

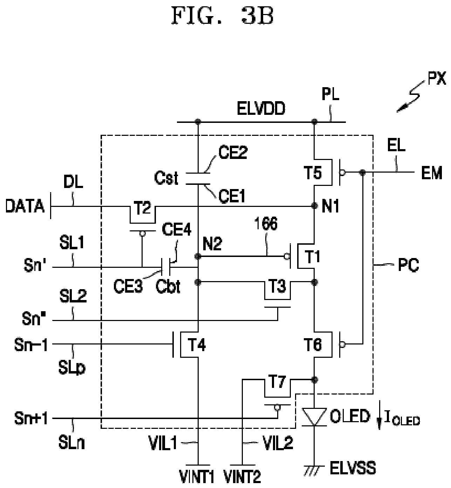

FIGS. 3A and 3B are equivalent circuit diagrams each illustrating a display element of a display panel and a sub-pixel circuit electrically connected to the display element, according to an embodiment. Referring to FIG. 3A, one sub-pixel PX may include a sub-pixel circuit PC and an organic light-emitting diode OLED that is a display element electrically connected to the sub-pixel circuit PC.

In an embodiment, for example, the sub-pixel circuit PC may include a plurality of thin-film transistors T1 to T7 and a capacitor Cst. In an embodiment, the plurality of thin-film transistors T1 to T7 may include a driving transistor T1, a switching transistor T2, a compensation transistor T3, a first initialization transistor T4, an operation control transistor T5, an emission control transistor T6, and a second initialization transistor T7. However, the disclosure is not limited thereto.

The organic light-emitting diode OLED may include a sub-pixel electrode and an opposite electrode. The sub-pixel electrode of the organic light-emitting diode OLED may be connected to the driving transistor T1 via the emission control transistor T6 to receive a driving current, and the opposite electrode may be provided with a common voltage ELVSS. The organic light-emitting diode OLED may generate light having luminance corresponding to the driving current.

In an embodiment, all of the plurality of thin-film transistors T1 to T7 may be PMOS transistors. The plurality of thin-film transistors T1 to T7 may include amorphous silicon or polycrystalline silicon.

Signal lines may include a first scan line SL1, a previous scan line SLp, a subsequent scan line SLn, an emission control line EL, and a data line DL. However, the disclosure is not limited thereto. The first scan line SL1 may be configured to transmit a first scan signal Sn in another embodiment. The previous scan line SLp may be configured to transmit a previous scan signal Sn-1 to the first initialization transistor T4. The subsequent scan line SLn may be configured to transmit a subsequent scan signal Sn+1 to the second initialization transistor T7. The emission control line EL may be configured to transmit an emission control signal EM to the operation control transistor T5 and the emission control transistor T6. The data line DL may be configured to transmit a data signal DATA.

A driving voltage line PL may be configured to transmit a driving voltage ELVDD to the driving transistor T1, and an initialization voltage line VIL may be configured to transmit an initialization voltage VINT for initializing the driving transistor T1 and the organic light-emitting diode OLED to the sub-pixel PX. Specifically, a first initialization voltage line VIL1 may be configured to transmit the initialization voltage VINT to the first initialization transistor T4, and a second initialization voltage line VIL2 may be configured to transmit the initialization voltage VINT to the second initialization transistor T7.

A driving gate electrode of the driving transistor T1 may be connected to the capacitor Cst, one of a source region and a drain region of the driving transistor T1 may be connected to the driving voltage line PL via the operation control transistor T5 through a first node N1, and the other of the source region and the drain region of the driving transistor T1 may be electrically connected to the sub-pixel electrode of the organic light-emitting diode OLED via the emission control transistor T6. The driving transistor T1 may be configured to receive the data signal DATA according to a switching operation of the switching transistor T2 and supply a driving current I_{OLED} to the organic light-emitting diode OLED.

A switching gate electrode of the switching transistor T2 may be connected to the first scan line SL1 configured to transmit the first scan signal Sn, one of a source region and a drain region of the switching transistor T2 may be connected to the data line DL, and the other of the source region and the drain region of the switching transistor T2 may be connected to the driving transistor T1 through the first node N1 and connected to the driving voltage line PL via the operation control transistor T5. The switching transistor T2 may be configured to be turned on according to the first scan signal Sn received through the first scan line SL1 and transfer the data signal DATA, which is transmitted through the data line DL, to the driving transistor T1 through the first node N1.

A compensation gate electrode of the compensation transistor T3 may be connected to the first scan line SL1. One of a source region and a drain region of the compensation transistor T3 may be connected to the sub-pixel electrode of the organic light-emitting diode OLED via the emission control transistor T6. The other of the source region and the drain region of the compensation transistor T3 may be connected to the capacitor Cst and the driving gate electrode of the driving transistor T1. The compensation transistor T3 may be configured to be turned on according to the first scan signal Sn received through the first scan line SL1 and diode-connect the driving transistor T1.

A first initialization gate electrode of the first initialization transistor T4 may be connected to the previous scan line SLp. One of a source region and a drain region of the first initialization transistor T4 may be connected to the first initialization voltage line VIL1. The other of the source region and the drain region of the first initialization transistor T4 may be connected to a first capacitor electrode CE1 of the capacitor Cst and the driving gate electrode of the driving transistor T1. The first initialization transistor T4 may be configured to be turned on according to the previous scan signal Sn-1 received through the previous scan line SLp and transfer the initialization voltage VINT to the driving gate electrode of the driving transistor T1 to initialize the voltage of the driving gate electrode of the driving transistor T1.

An operation control gate electrode of the operation control transistor T5 may be connected to the emission control line EL, one of a source region and a drain region of the operation control transistor T5 may be connected to the driving voltage line PL, and the other may be connected to the driving transistor T1 and the switching transistor T2 through the first node N1.

An emission control gate electrode of the emission control transistor T6 may be connected to the emission control line EL, one of a source region and a drain region of the emission control transistor T6 may be connected to the driving transistor T1 and the compensation transistor T3, and the other of the source region and the drain region of the emission control transistor T6 may be electrically connected to the sub-pixel electrode of the organic light-emitting diode OLED.

The operation control transistor T5 and the emission control transistor T6 may be simultaneously turned on according to the emission control signal EM received through the emission control line EL, and thus, the driving voltage ELVDD may be transferred to the organic light-emitting diode OLED to allow the driving current I_{OLED} to flow through the organic light-emitting diode OLED.

A second initialization gate electrode of the second initialization transistor T7 may be connected to the subsequent scan line SLn, one of a source region and a drain region of the second initialization transistor T7 may be connected to the sub-pixel electrode of the organic light-emitting diode OLED, and the other of the source region and the drain region of the second initialization transistor T7 may be connected to the second initialization voltage line VIL2 to receive the initialization voltage VINT. Th second initialization transistor T7 may be configured to be turned on according to the subsequent scan signal Sn+1 received through the subsequent scan line SLn and initialize the sub-pixel electrode of the organic light-emitting diode OLED. The subsequent scan line SLn may be the same as the first scan line SL1. In this case, the relevant scan line may be configured to transmit the same electric signal with a time difference, and thus, may function as the first scan line SL1 and as the subsequent scan line SLn. In some embodiments, the second initialization transistor T7 may be omitted.

The capacitor Cst may be connected to the driving voltage line PL and the driving gate electrode of the driving transistor T1 and store and maintain a voltage corresponding to a voltage difference between opposite ends of the capacitor Cst, thereby maintaining a voltage applied to the driving gate electrode of the driving transistor T.

Detailed operations of the sub-pixel circuit PC and the organic light-emitting diode OLED, which is a display element, according to an embodiment are described below.

During an initialization period, when a previous scan signal Sn-1 is supplied through the previous scan line SLp, the first initialization transistor T4 is turned on according to the previous scan signal Sn-1, and the driving transistor T1 may be initialized by the initialization voltage VINT supplied from the first initialization voltage line VIL1.

During a data programming period, when a first scan signal Sn is supplied through the first scan line SL1, the switching transistor T2 and the compensation transistor T3 may be turned on in response to the first scan signal Sn. In this case, the driving transistor T1 may be diode-connected and forward-biased by the compensation transistor T3 that is turned on. Then, a compensation voltage (DATA+Vth (Vth has a (-) value)) may be applied to the driving gate electrode of the driving transistor T1, wherein the compensation voltage (DATA+Vth) is obtained by subtracting a threshold voltage Vth of the driving transistor T1 from a data signal DATA supplied from the data line DL. The driving voltage ELVDD and the compensation voltage (DATA+Vth) are applied to two opposite ends of the capacitor Cst, respectively, and charge corresponding to a difference between voltages of the two opposite ends may be stored in the capacitor Cst.

During an emission period, the operation control transistor T5 and the emission control transistor T6 may be turned on according to an emission control signal En supplied from the emission control line EL. The driving current I_{OLED} corresponding to a voltage difference between the voltage of the driving gate electrode of the driving transistor T1 and the driving voltage ELVDD may be generated, and the driving current I_{OLED} may be supplied to the organic light-emitting diode OLED through the emission control transistor T6.

Referring to FIG. 3B, a sub-pixel circuit PC of the sub-pixel PX may include a plurality of thin-film transistors T1 to T7, a first capacitor Cst, a second capacitor Cbt, and an organic light-emitting diode OLED that is a display element.

Some of the plurality of thin-film transistors T1 to T7 may be n-channel MOSFET ("NMOS") transistors, and others may be p-channel MOSFET ("PMOS") transistors. In an embodiment, for example, as shown in FIG. 3B, among the plurality of thin-film transistors T1 to T7, a compensation transistor T3 and a first initialization transistor T4 may be NMOS transistors, and the rest may be PMOS transistors. Alternatively, among the plurality of thin-film transistors T1 to T7, the compensation transistor T3, the first initialization transistor T4, and a second initialization transistor T7 may be NMOS transistors, and the rest may be PMOS transistors. Alternatively, all of the plurality of thin-film transistors T1 to T7 may be NMOS transistors. The plurality of thin-film transistors T1 to T7 may include amorphous silicon or polycrystalline silicon. In another embodiment, each of the NMOS transistors may include an oxide semiconductor.

Signal lines may include a first scan line SL1 configured to transmit a first scan signal Sn', a second scan line SL2 configured to transmit a second scan signal Sn", a previous scan line SLp configured to transmit a previous scan signal Sn-1 to the first initialization transistor T4, an emission control line EL configured to transmit an emission control signal EM to an operation control transistor T5 and an emission control transistor T6, a subsequent scan line SLn configured to transmit a subsequent scan signal Sn+1 to the second initialization transistor T7, and a data line DL configured to transmit a data signal DATA.

A driving transistor T1 may be connected to a driving voltage line PL via the operation control transistor T5 and may be electrically connected to the organic light-emitting diode OLED via the emission control transistor T6. The driving transistor T1 may be configured to receive the data signal DATA according to a switching operation of a switching transistor T2 and supply a driving current I_{OLED} to the organic light-emitting diode OLED.

The switching transistor T2 may be connected to the first scan line SL1 and the data line DL and may be connected to the driving voltage line PL via the operation control transistor T5. The switching transistor T2 may be configured to be turned on according to the first scan signal Sn' received through the first scan line SL1 and transfer the data signal DATA, which is transmitted through the data line DL, to the first node N1.

The compensation transistor T3 may be connected to the second scan line SL2 and may be connected to the organic light-emitting diode OLED via the emission control transistor T6. The compensation transistor T3 may be configured to be turned on according to the second scan signal Sn" received through the second scan line SL2 and diode-connect the driving transistor T1 to thereby compensate the threshold voltage of the driving transistor T1.

The first initialization transistor T4 may be connected to the previous scan line SLp and the first initialization voltage line VIL1, and may be configured to be turned on according to the previous scan signal Sn-1 received through the previous scan line SLp and transfer a first initialization voltage VINT1 from the first initialization voltage line VIL1 to a gate electrode of the driving transistor T1 to initialize the voltage of the gate electrode of the driving transistor T1.

The operation control transistor T5 and the emission control transistor T6 may be connected to the emission control line EL, and may be configured to be simultaneously turned on according to the emission control signal EM received through the emission control line EL and form a current path so that a driving current I_{OLED} may flow from the driving voltage line PL to the organic light-emitting diode OLED.

The second initialization transistor T7 may be connected to the subsequent scan line SLn and the second initialization voltage line VIL2, and may be configured to be turned on according to the subsequent scan signal Sn+1 received through the subsequent scan line SLn and transfer a second initialization voltage VINT2 from the second initialization voltage line VIL2 to the organic light-emitting diode OLED to initialize the organic light-emitting diode OLED. The second initialization transistor T7 may be omitted.

The first capacitor Cst may include a first capacitor electrode CE1 and a second capacitor electrode CE2. The first capacitor electrode CE1 may be connected to the gate electrode of the driving transistor T1, and the second capacitor electrode CE2 may be connected to the driving voltage line PL. The first capacitor Cst may maintain a voltage applied to the gate electrode of the driving transistor T1 by storing and maintaining a voltage corresponding to a voltage difference between the driving voltage line PL and the gate electrode of the driving transistor T1.

The second capacitor Cbt may include a third capacitor electrode CE3 and a fourth capacitor electrode CE4. The third capacitor electrode CE3 may be connected to the first scan line SL1 and a gate electrode of the switching transistor T2. The fourth capacitor electrode CE4 may be connected to the gate electrode of the driving transistor T1 and the first capacitor electrode CE1 of the first capacitor Cst. The second capacitor Cbt is a boosting capacitor, and when the first scan signal Sn of the first scan line SL1 has a voltage for turning off the switching transistor T2, the second capacitor Cbt may increase the voltage of the second node N2 to clearly express a black gradation.

In an embodiment, at least one of the plurality of thin-film transistors T1 to T7 may include a semiconductor layer including oxide, and the rest may include a semiconductor layer including amorphous silicon or polycrystalline silicon.

Specifically, the driving transistor T1 that directly affects the brightness of the display apparatus may include a semiconductor layer including polycrystalline silicon having high reliability, thereby realizing a high-resolution display apparatus.

Because an oxide semiconductor has high carrier mobility and low leakage current, a voltage drop may not be large even though a driving time is long. That is, because a color change of an image according to a voltage drop is not large even during low-frequency driving, low-frequency driving may be possible.

As described above, because an oxide semiconductor has an advantage of a small leakage current, at least one of the compensation transistor T3 and the first initialization transistor T4 connected to the gate electrode of the driving transistor T1 may employ an oxide semiconductor to thereby prevent leakage current flowing to the gate electrode of the driving transistor T1 and reduce power consumption.

The sub-pixel circuit PC is not limited to the number and circuit design of thin-film transistors and capacitors described with reference to FIGS. 3A and 3B, and the number and circuit design may be variously changed.

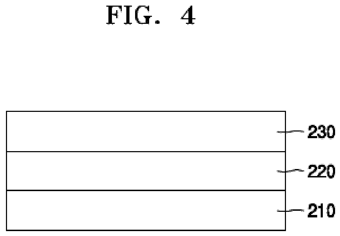

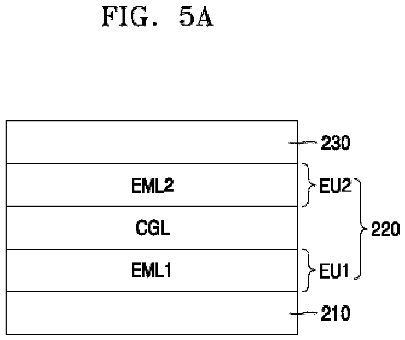

FIG. 4 is a cross-sectional view illustrating a structure of a display element according to an embodiment. FIGS. 5A to 5D are cross-sectional views illustrating structures of a display element according to an embodiment.

Referring to FIG. 4, the organic light-emitting diode OLED (see FIGS. 3A and 3B) as a display element according to an embodiment may include a sub-pixel electrode 210, an opposite electrode 230, and an intermediate layer 220 between the sub-pixel electrode 210 (anode) and the opposite electrode 230 (cathode).

The sub-pixel electrode 210 may include a light-transmitting conductive oxide, such as indium tin oxide ("ITO"), indium zinc oxide ("IZO"), zinc oxide (ZnO), indium oxide (In₂O₃), indium gallium oxide ("IGO"), or aluminum zinc oxide ("AZO"). The sub-pixel electrode 210 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or a compound thereof. In an embodiment, for example, the sub-pixel electrode 210 may have a three-layered structure including ITO/Ag/ITO layers. The opposite electrode 230 may be disposed on the intermediate layer 220. The opposite electrode 230 may include a low work function metal, an alloy, an electrically conductive compound, or a combination thereof. In an embodiment, for example, the opposite electrode 230 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or a combination thereof. The opposite electrode 230 may be a transmissive electrode, a transflective electrode, or a reflective electrode.

The intermediate layer 220 may include a high molecular weight or low molecular weight organic material that emits light of a certain color. In addition to various organic materials, the intermediate layer 220 may further include a metal-containing compound such as an organometallic compound, an inorganic material such as quantum dots, and the like.

In an embodiment, the intermediate layer 220 may include one emission layer and a first functional layer and a second functional layer, which are below and above the one emission layer, respectively. In an embodiment, for example, the first functional layer may include a hole transport layer ("HTL") or may include an HTL and a hole injection layer ("HIL"). The second functional layer is a component disposed on the emission layer and is optional. The second functional layer may include an electron transport layer ("ETL") and/or an electron injection layer ("EIL").

In an embodiment, the intermediate layer 220 may include two or more emitting units sequentially stacked between the sub-pixel electrode 210 and the opposite electrode 230, and a charge generation layer disposed between two emitting units. When the intermediate layer 220 includes an emitting unit and a charge generation layer, the organic light-emitting diode OLED may be a tandem light-emitting device. The organic light-emitting diode OLED may improve color purity and luminous efficiency by having a stacked structure including a plurality of emitting units.

One emitting unit may include an emission layer, and a first functional layer and a second functional layer, which are below and above the one emission layer, respectively. The charge generation layer may include a negative charge generation layer and a positive charge generation layer. The luminous efficiency of the organic light-emitting diode OLED, which is a tandem light-emitting device including a plurality of emission layers, may be further increased by the negative charge generation layer and the positive charge generation layer.

The negative charge generation layer may be an n-type charge generation layer. The negative charge generation layer may supply electrons. The negative charge generation layer may include a host and a dopant. The host may include an organic material. The dopant may include a metal material. The positive charge generation layer may be a p-type charge generation layer. The positive charge generation layer may supply holes. The positive charge generation layer may include a host and a dopant. The host may include an organic material. The dopant may include a metal material. In an embodiment, as shown in FIG. 5A, the organic light-emitting diode OLED may include a first emitting unit EU1 including a first emission layer EML1 and a second emitting unit EU2 including a second emission layer EML2, which are sequentially stacked. A charge generation layer CGL may be provided between the first emitting unit EU1 and the second emitting unit EU2. In an embodiment, for example, the organic light-emitting diode OLED may include a sub-pixel electrode 210, a first emission layer EML1, a charge generation layer CGL, a second emission layer EML2, and an opposite electrode 230, which are sequentially stacked. A first functional layer and a second functional layer may be provided below and above the first emission layer EML1, respectively. A first functional layer and a second functional layer may be provided below and above the second emission layer EML2, respectively. The first emission layer EML1 may be a blue emission layer, and the second emission layer EML2 may be a yellow emission layer.

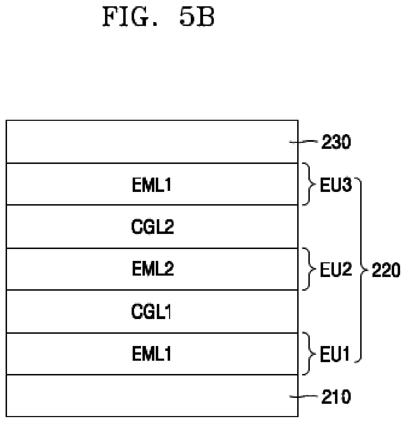

In an embodiment, as shown in FIG. 5B, the organic light-emitting diode OLED may include a first emitting unit EU1 and a third emitting unit EU3, each of which includes a first emission layer EML1, and a second emitting unit EU2 including a second emission layer EML2. A first charge generation layer CGL1 may be provided between the first emitting unit EU1 and the second emitting unit EU2, and a second charge generation layer CGL2 may be provided between the second emitting unit EU2 and the third emitting unit EU3. In an embodiment, for example, the organic light-emitting diode OLED may include a sub-pixel electrode 210, a first emission layer EML1, a first charge generation layer CGL1, a second emission layer EML2, a second charge generation layer CGL2, a first emission layer EML1, and an opposite electrode 230, which are sequentially stacked. A first functional layer and a second functional layer may be provided below and above the first emission layer EML1, respectively.

A first functional layer and a second functional layer may be provided below and above the second emission layer EML2, respectively. The first emission layer EML1 may be a blue emission layer, and the second emission layer EML2 may be a yellow emission layer.

In an embodiment, in the organic light-emitting diode OLED, the second emitting unit EU2 may further include a third emission layer EML3 and/or a fourth emission layer EML4 directly contacting the second emission layer EML2 below and/or above the second emission layer EML2, in addition to the second emission layer EML2. In this case, direct contact may mean that no other layer is disposed between the second emission layer EML2 and the third emission layer EML3 and/or between the second emission layer EML2 and the fourth emission layer EML4. The third emission layer EML3 may be a red emission layer, and the fourth emission layer EML4 may be a green emission layer.

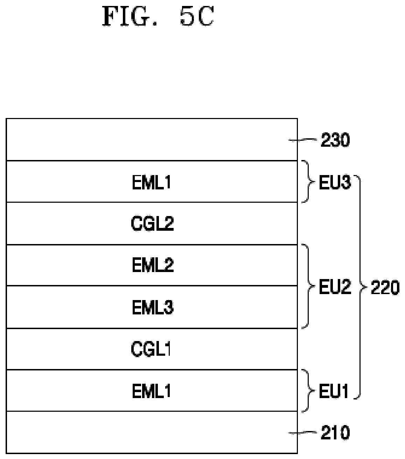

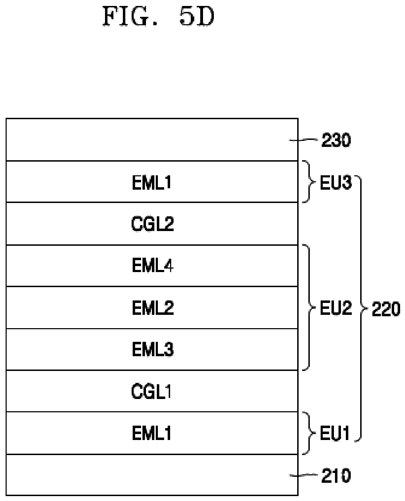

In an embodiment, for example, as shown in FIG. 5C, the organic light-emitting diode OLED may include a sub-pixel electrode 210, a first emission layer EML1, a first charge generation layer CGL1, a third emission layer EML3, a second emission layer EML2, a second charge generation layer CGL2, a first emission layer EML1, and an opposite electrode 230, which are sequentially stacked. Alternatively, as shown in FIG. 5D, the organic light-emitting diode OLED may include a sub-pixel electrode 210, a first emission layer EML1, a first charge generation layer CGL1, a third emission layer EML3, a second emission layer EML2, a fourth emission layer EML4, a second charge generation layer CGL2, a first emission layer EML1, and an opposite electrode 230, which are sequentially stacked.

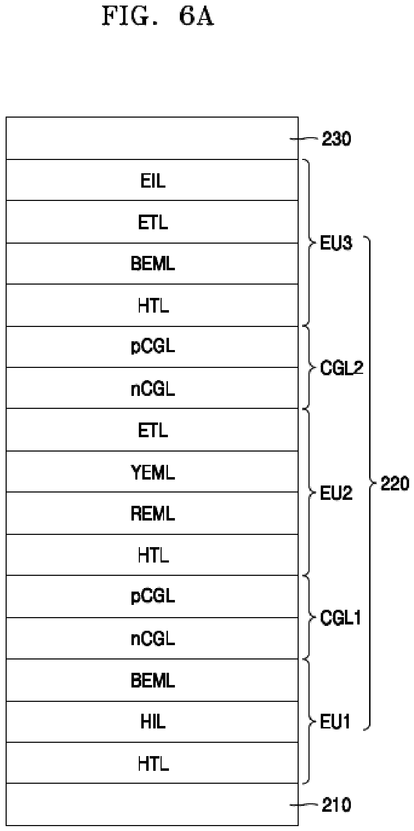

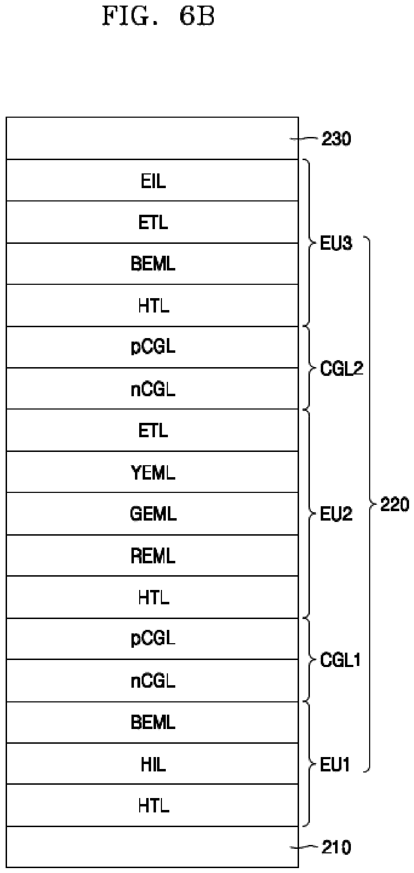

FIG. 6A is a cross-sectional view showing an example of the organic light-emitting diode of FIG. 5C, and FIG. 6B is a cross-sectional view showing an example of the organic light-emitting diode of FIG. 5D.

Referring to FIG. 6A, the organic light-emitting diode OLED may include a first emitting unit EU1, a second emitting unit EU2, and a third emitting unit EU3, which are sequentially stacked. A first charge generation layer CGL1 may be provided between the first emitting unit EU1 and the second emitting unit EU2, and a second charge generation layer CGL2 may be provided between the second emitting unit EU2 and the third emitting unit EU3. The first charge generation layer CGL1 and the second charge generation layer CGL2 may include a negative charge generation layer nCGL and a positive charge generation layer pCGL, respectively.

The first emitting unit EU1 may include a blue emission layer BEML. The first emitting unit EU1 may further include a hole injection layer HIL and a hole transport layer HTL between the sub-pixel electrode 210 and the blue emission layer BEML. In an embodiment, a p-doped layer may be further included between the hole injection layer HIL and the hole transport layer HTL. The p-doped layer may be formed by doping the hole injection layer HIL with a p-type doping material. In an embodiment, at least one of a blue light auxiliary layer, an electron blocking layer, and a buffer layer may be further included between the blue emission layer BEML and the hole transport layer HTL. The blue light auxiliary layer may increase light emission efficiency of the blue emission layer BEML. The blue light auxiliary layer may increase light emission efficiency of the blue emission layer BEML by adjusting hole charge balance. The electron blocking layer may prevent injection of electrons into the hole transport layer HTL. The buffer layer may compensate for a resonance distance according to a wavelength of light emitted from an emission layer.

The second emitting unit EU2 may include a yellow emission layer YEML and a red emission layer REML directly contacting the yellow emission layer YEML below the yellow emission layer YEML. The second emitting unit EU2 may further include a hole transport layer HTL between the positive charge generation layer pCGL of the first charge generation layer CGL1 and the red emission layer REML, and may further include an electron transport layer ETL between the yellow emission layer YEML and the negative charge generation layer nCGL of the second charge generation layer CGL2. The third emitting unit EU3 may include a blue emission layer BEML. The third emitting unit EU3 may further include a hole transport layer HTL between the positive charge generation layer pCGL of the second charge generation layer CGL2 and the blue emission layer BEML. The third emitting unit EU3 may further include an electron transport layer ETL and an electron injection layer EIL between the blue emission layer BEML and the opposite electrode 230. The electron transport layer ETL may include a single layer or multiple layers. In an embodiment, at least one of a blue light auxiliary layer, an electron blocking layer, and a buffer layer may be further included between the blue emission layer BEML and the hole transport layer HTL. At least one of a hole blocking layer and a buffer layer may be further included between the blue emission layer BEML and the electron transport layer ETL. The hole blocking layer may prevent hole injection into the electron transport layer ETL.

The organic light-emitting diode OLED shown in FIG. 6B is different from the organic light-emitting diode OLED shown in FIG. 6A in the stacked structure of the second emitting unit EU2, whereas the other configurations are the same. Referring to FIG. 6B, the second emitting unit EU2 may include a yellow emission layer YEML, a red emission layer REML directly contacting the yellow emission layer YEML below the yellow emission layer YEML, and a green emission layer GEML directly contacting the yellow emission layer YEML above the yellow emission layer YEML. The second emitting unit EU2 may further include a hole transport layer HTL between the positive charge generation layer pCGL of the first charge generation layer CGL1 and the red emission layer REML, and may further include an electron transport layer ETL between the green emission layer GEML and the negative charge generation layer nCGL of the second charge generation layer CGL2.

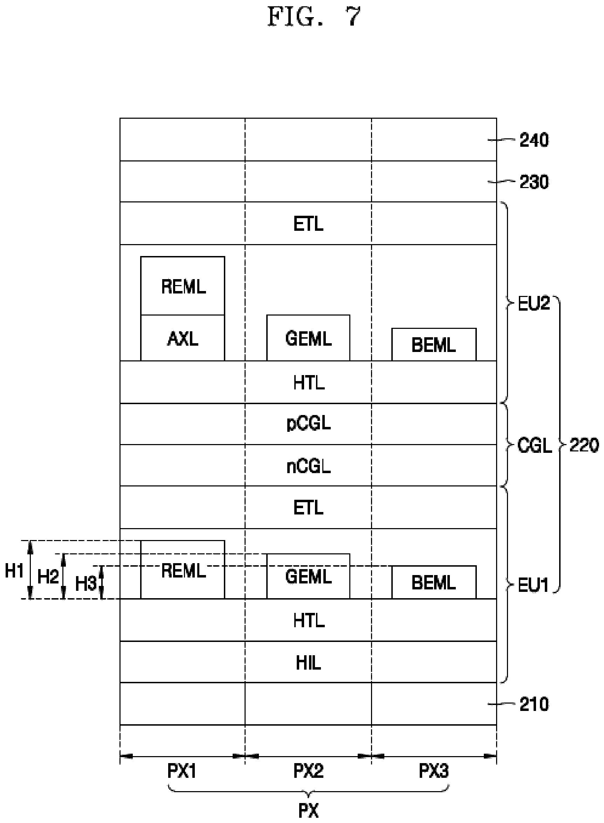

FIG. 7 is a cross-sectional view illustrating a structure of a sub-pixel of a display apparatus according to an embodiment.

Referring to FIG. 7, the display apparatus may include a plurality of sub-pixels. The plurality of sub-pixels PX may include a first sub-pixel PX1, a second sub-pixel PX2, and a third sub-pixel PX3. Each of the first sub-pixel PX1, the second sub-pixel PX2, and the third sub-pixel PX3 may include a sub-pixel electrode 210, an opposite electrode 230, and an intermediate layer 220. In an embodiment, the first sub-pixel PX1 may be a red pixel, the second sub-pixel PX2 may be a green pixel, and the third sub-pixel PX3 may be a blue pixel.

The sub-pixel electrode 210 may be independently provided in each of the first sub-pixel PX1, the second sub-pixel PX2, and the third sub-pixel PX3.

The intermediate layer 220 of each of the first sub-pixel PX1, the second sub-pixel PX2, and the third sub-pixel PX3 may include a first emitting unit EU1, a second emitting unit EU2, and a charge generation layer CGL between the first emitting unit EU1 and the second emitting unit EU2, which are sequentially stacked. The charge generation layer CGL may include a negative charge generation layer nCGL and a positive charge generation layer pCGL. The charge generation layer CGL may be a common layer continuously formed in the first sub-pixel PX1, the second sub-pixel PX2, and the third sub-pixel PX3.

The first emitting unit EU1 of the first sub-pixel PX1 may include a hole injection layer HIL, a hole transport layer HTL, a red emission layer REML, and an electron transport layer ETL, which are sequentially stacked on the sub-pixel electrode 210. The first emitting unit EU1 of the second sub-pixel PX2 may include a hole injection layer HIL, a hole transport layer HTL, a green emission layer GEML, and an electron transport layer ETL, which are sequentially stacked on the sub-pixel electrode 210. The first emitting unit EU1 of the third sub-pixel PX3 may include a hole injection layer HIL, a hole transport layer HTL, a blue emission layer BEML, and an electron transport layer ETL, which are sequentially stacked on the sub-pixel electrode 210. Each of the hole injection layer HIL, the hole transport layer HTL, and the electron transport layer ETL of the first emitting unit EU1 may be a common layer continuously formed in the first sub-pixel PX1, the second sub-pixel PX2, and the third sub-pixel PX3.

The second emitting unit EU2 of the first sub-pixel PX1 may include a hole transport layer HTL, an auxiliary layer AXL, a red emission layer REML, and an electron transport layer ETL, which are sequentially stacked on the charge generation layer CGL. The second emitting unit EU2 of the second sub-pixel PX2 may include a hole transport layer HTL, a green emission layer GEML, and an electron transport layer ETL, which are sequentially stacked on the charge generation layer CGL. The second emitting unit EU2 of the third sub-pixel PX3 may include a hole transport layer HTL, a blue emission layer BEML, and an electron transport layer ETL, which are sequentially stacked on the charge generation layer CGL. Each of the hole transport layer HTL and the electron transport layer ETL of the second emitting unit EU2 may be a common layer continuously formed in the first sub-pixel PX1, the second sub-pixel PX2, and the third sub-pixel PX3. In an embodiment, in the second emitting unit EU2 of the first sub-pixel PX1, the second sub-pixel PX2, and the third sub-pixel PX3, at least one of a hole blocking layer and a buffer layer may be further provided between an emission layer and the electron transport layer ETL.

A thickness H1 of the red emission layer REML, a thickness H2 of the green emission layer GEML, and a thickness H3 of the blue emission layer BEML may be determined according to a resonance distance. The auxiliary layer AXL is a layer added to adjust the resonance distance and may include a resonance auxiliary material. In an embodiment, for example, the auxiliary layer AXL may include the same material as the hole transport layer HTL.

Although the auxiliary layer AXL is provided only in the first sub-pixel PX1 in FIG. 7, the embodiment is not limited thereto. In another embodiment, for example, the auxiliary layer AXL may be provided in at least one of the first sub-pixel PX1, the second sub-pixel PX2, and the third sub-pixel PX3 to adjust the resonance distance of each of the first sub-pixel PX1, the second sub-pixel PX2, and the third sub-pixel PX3.

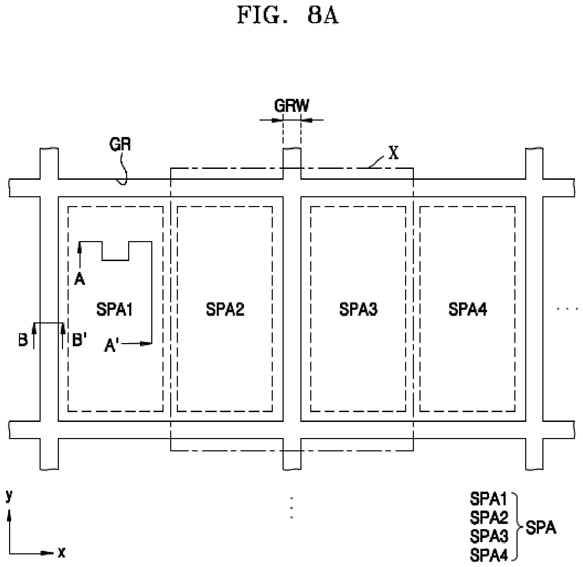

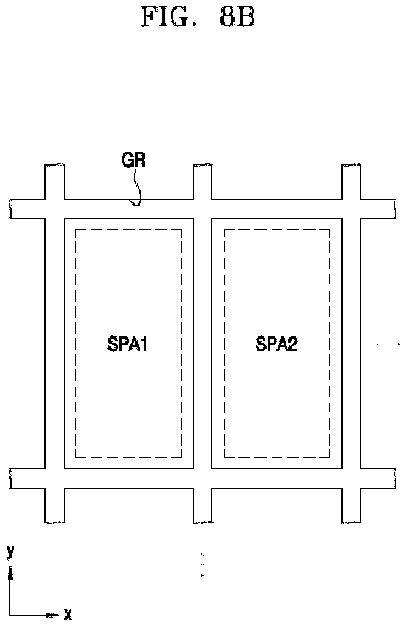

The display apparatus may further include a capping layer 240 disposed outside the opposite electrode 230. The capping layer 240 may improve luminous efficiency by the principle of constructive interference. As a result, the light extraction efficiency of the organic light-emitting diode OLED may increase, and thus, the luminous efficiency of the organic light-emitting diode OLED may be improved. FIGS. 8A and 8B are schematic plan views of a display apparatus according to an embodiment.

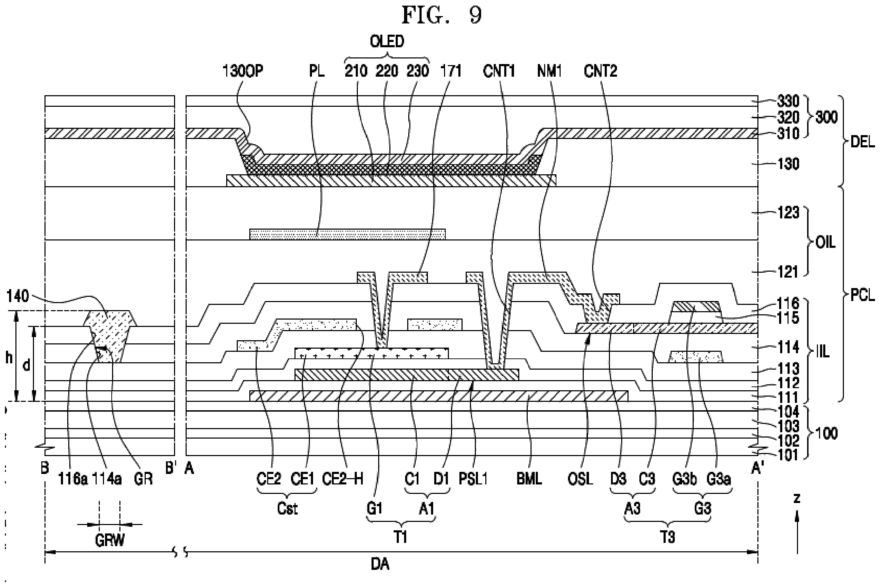

Referring to FIGS. 8A and 8B, the display area DA (see FIGS. 1A and 1B) may include a plurality of sub-pixel areas SPA. Each of the sub-pixels PX may include an organic light-emitting diode OLED (see FIG. 9) as a display element and a sub-pixel circuit. In the present specification, an area where the sub-pixel PX is disposed, specifically an area where the sub-pixel circuit is disposed is referred to as a sub-pixel area SPA. Sub-pixel circuits may be arranged to form rows and columns. The sub-pixel circuits may be arranged in a first direction (e.g., an x direction) and a second direction (e.g., a y direction).

In an embodiment, at least some of the sub-pixel circuits arranged in the display area DA may be surrounded by a groove GR. In other words, at least some of the sub-pixel areas SPA included in the display area DA may be surrounded by the groove GR. In an embodiment, the groove GR may be defined to group and surround a plurality of sub-pixel areas SPA. In this regard, FIG. 8A shows that two adjacent sub-pixel areas SPA are surrounded by the groove GR. In an embodiment, for example, the groove GR may be disposed to group and surround a first sub-pixel area SPA1 and a second sub-pixel area SPA2, which are adjacent to each other, and to group and surround a third sub-pixel area SPA3 and a fourth sub-pixel area SPA4, which are adjacent to each other. The number of sub-pixel areas SPA to be grouped may be variously modified. In another embodiment, as shown in FIG. 8B, the groove GR may be defined to surround each of the plurality of sub-pixel areas SPA. However, the disclosure is not limited thereto.

In some embodiments, the groove GR may be modified in various ways. In an embodiment, for example, the groove GR may be defined to extend in the second direction (e.g., the y direction) in an area between the sub-pixel areas SPA without surrounding at least some of the sub-pixel areas SPA. The groove GR may be defined in an inorganic insulating layer included in the display apparatus and may have a concave shape from an upper surface of the inorganic insulating layer toward a lower surface thereof. The inside of the groove GR may be filled with an organic material. The groove GR may be introduced to reduce damage to the display apparatus due to external impact. The groove GR may suppress the generation of micro-cracks and prevent the propagation of micro-cracks. Accordingly, a flexible display apparatus that is robust against external impact may be provided through the groove GR structure.

FIG. 9 schematically illustrates a display apparatus according to an embodiment, and is a cross-sectional view of the display apparatus taken along lines A-A' and B-B' in FIG. 8A.

Referring to a cross-section taken along line A-A' of FIG. 9, the display apparatus may include a display panel, which includes a substrate 100, a sub-pixel circuit layer PCL, and a display element layer DEL.

The sub-pixel circuit layer PCL may define a sub-pixel circuit. The sub-pixel circuit layer PCL may include components of a plurality of thin-film transistors and capacitors and a plurality of insulating layers disposed below and/or above the components. In this regard, FIG. 9 shows a driving transistor T1, a compensation transistor T3, and a first capacitor Cst, from among thin-film transistors and capacitors included in the sub-pixel circuit. Also, the sub-pixel circuit layer PCL may include inorganic insulating layers IIL and organic insulating layers OIL. In an embodiment, for example, as shown in FIG. 9, the inorganic insulating layers IIL may include a buffer layer 111, a first gate insulating layer 112, a first interlayer-insulating layer 113, a second interlayer-insulating layer 114, a second gate insulating layer 115, and a third interlayer-insulating layer 116. The organic insulating layers OIL may include a first organic insulating layer 121 and a second organic insulating layer 123.

The substrate 100 may include a glass material, a ceramic material, a metal material, a plastic material, or a material that is flexible or bendable. When the substrate 100 is flexible or bendable, the substrate 100 may include polymer resin, such as polyethersulphone ("PES"), polyacrylate, polyetherimide ("PEI"), polyethylene naphthalate ("PEN"), polyethylene terephthalate ("PET"), polyphenylene sulfide ("PPS"), polyarylate, polyimide ("PI"), polycarbonate ("PC"), or cellulose acetate propionate ("CAP").

The substrate 100 may have a single-layered or multi-layered structure including the material described above, and may further include an inorganic material layer in the case of a multi-layered structure. In an embodiment, for example, the substrate 100 may include a first organic base layer 101, a first inorganic barrier layer 102, a second organic base layer 103, and a second inorganic barrier layer 104. Each of the first organic base layer 101 and the second organic base layer 103 may include polymer resin. The first inorganic barrier layer 102 and the second inorganic barrier layer 104 are barrier layers that prevent penetration of external foreign materials, and may have a single-layered or multi-layered structure including an inorganic insulating material, such as silicon nitride and/or silicon oxide.

A lower metal layer BML may be disposed on the substrate 100. The lower metal layer BML may include one or more materials selected from Al, Pt, Pd, Ag, Mg, Au, Ni, Nd, Ir, Cr, Li, Ca, Mo, Ti, W, and Cu. In some embodiments, the lower metal layer BML may have a single-layered structure including Mo, a double-layered structure in which a Mo layer and a Ti layer are stacked, or a triple-layered structure in which a Ti layer, an Al layer, and a Ti layer are stacked.

The buffer layer 111 may be disposed on the lower metal layer BML. The buffer layer 111 may be an inorganic insulating layer including an inorganic insulating material, such as silicon nitride and/or silicon oxide, and may have a single-layered or multi-layered structure including the aforementioned inorganic insulating material.

Silicon semiconductor layers of silicon-based transistors may be disposed on the buffer layer 111. In this regard, FIG. 9 shows a first semiconductor layer A1 of the driving transistor T1 corresponding to a portion of a first silicon semiconductor pattern PSL1. The first semiconductor layer A1 may include a first channel region C1 and impurity regions disposed on opposite sides of the first channel region C1 and doped with impurities, respectively. In this regard, FIG. 9 shows a second region D1 that is one of the impurity regions and disposed on one side of the first channel region C1.

The first gate insulating layer 112 may be disposed on the first silicon semiconductor pattern PSL1. The first gate insulating layer 112 may be an inorganic insulating layer including an inorganic insulating material, such as silicon oxide, silicon nitride, and/or silicon oxynitride, and may have a single-layered or multi-layered structure including the aforementioned inorganic insulating material. A first gate electrode G1 and a first capacitor electrode CE1 may be disposed on the first gate insulating layer 112. FIG. 9 shows that the first gate electrode G1 is formed integrally with the first capacitor electrode CE1. In other words, the first gate electrode G1 may perform the function of the first capacitor electrode CE1, or the first capacitor electrode CE1 may perform the function of the first gate electrode G1.

The first gate electrode G1 and/or the first capacitor electrode CE1 may include Al, Pt, Pd, Ag, Mg, Au, Ni, Nd, Ir, Cr, Li, Ca, Mo, Ti, W, and/or Cu, and may include a single layer or multiple layers including the aforementioned materials.

The first interlayer-insulating layer 113 may be disposed on the first gate electrode G1 and/or the first capacitor electrode CE1. The first interlayer-insulating layer 113 may be an inorganic insulating layer including an inorganic insulating material, such as silicon oxide, silicon nitride, and/or silicon oxynitride, and may have a single-layered or multi-layered structure including the aforementioned inorganic insulating material.

A second capacitor electrode CE2 may be disposed on the first interlayer-insulating layer 113. The second capacitor electrode CE2 may include Al, Pt, Pd, Ag, Mg, Au, Ni, Nd, Ir, Cr, Li, Ca, Mo, Ti, W, and/or Cu, and may include a single layer or multiple layers including the aforementioned materials. The second capacitor electrode CE2 may overlap the first gate electrode G1 and/or the first capacitor electrode CE1 in a plan view. The second capacitor electrode CE2 may define a hole CE2-H therein so that a node connection electrode 171 for electrically connecting the first gate electrode G1 of the driving transistor T1 to the compensation transistor T3 is connected to the first gate electrode G1. The hole CE2-H may partially overlap the first gate electrode G1 in a plan view.

The second interlayer-insulating layer 114 may be disposed on the second capacitor electrode CE2. The second interlayer-insulating layer 114 may be an inorganic insulating layer including an inorganic insulating material, such as silicon oxide, silicon nitride, and/or silicon oxynitride, and may have a single-layered or multi-layered structure including the aforementioned inorganic insulating material. Oxide semiconductor layers may be disposed on the second interlayer-insulating layer 114. In this regard, FIG. 9 shows a third semiconductor layer A3 of the compensation transistor T3 corresponding to a portion of an oxide semiconductor pattern OSL. The third semiconductor layer A3 may include a third channel region C3 and conductive regions disposed on opposite sides of the third channel region C3. In this regard, FIG. 9 shows a region D3 that is one of the conductive regions and disposed on one side of the third channel region C3. The vertical distance from the substrate 100 to the third semiconductor layer A3 may be greater than the vertical distance from the substrate 100 to the first semiconductor layer A1.

The third gate electrode G3 may be disposed below and/or above the third semiconductor layer A3. As an example, FIG. 9 shows that the third gate electrode G3 includes a third lower gate electrode G3a disposed below the third semiconductor layer A3 and a third upper gate electrode G3b disposed above the third semiconductor layer A3. In another embodiment, either the third lower gate electrode G3a or the third upper gate electrode G3b may be omitted.

The third lower gate electrode G3a may include the same material as the second capacitor electrode CE2 and may be located on the same layer (e.g., the first interlayer-insulating layer 113) as the second capacitor electrode CE2. The third upper gate electrode G3b may be disposed on the third semiconductor layer A3 with the second gate insulating layer 115 therebetween. The third upper gate electrode G3b may include Al, Pt, Pd, Ag, Mg, Au, Ni, Nd, Ir, Cr, Li, Ca, Mo, Ti, W, and/or Cu, and may include a single layer or multiple layers including the aforementioned materials.

Although FIG. 9 shows that the second gate insulating layer 115 is disposed only between the third upper gate electrode G3b and the third semiconductor layer A3, the disclosure is not limited thereto. In another embodiment, the second gate insulating layer 115 may be formed to entirely cover the substrate 100 like another insulating layer, for example, the first gate insulating layer 112. The second gate insulating layer 115 may be an inorganic insulating layer including an inorganic insulating material, such as silicon oxide, silicon nitride, and/or silicon oxynitride, and may have a single-layered or multi-layered structure including the aforementioned inorganic insulating material.

The third interlayer-insulating layer 116 may be disposed on the third upper gate electrode G3b. The third interlayer-insulating layer 116 may be an inorganic insulating layer including an inorganic insulating material, such as silicon oxide, silicon nitride, and/or silicon oxynitride, and may have a single-layered or multi-layered structure including the aforementioned inorganic insulating material. The node connection electrode 171 and a first connection electrode NM1 may be disposed on the third interlayer-insulating layer 116. Each of the node connection electrode 171 and the first connection electrode NM1 may include Al, Pt, Pd, Ag, Mg, Au, Ni, Nd, Ir, Cr, Li, Ca, Mo, Ti, W, and/or Cu, and may include a single layer or multiple layers including the aforementioned materials. In an embodiment, for example, each of the node connection electrode 171 and the first connection electrode NM1 may have a triple-layered structure in which a Ti layer, an Al layer, and a Ti layer are stacked.

The first connection electrode NM1 may electrically connect the first semiconductor layer A1 to the third semiconductor layer A3. The first connection electrode NM1 may be connected to a portion (e.g., the second region D1 of FIG. 9) of the first semiconductor layer A1 through a first contact hole CNT1 and may be connected to a portion (e.g., the region D3 of FIG. 9) of the third semiconductor layer A3 through a second contact hole CNT2. The first contact hole CNT1 may pass through inorganic insulating layers between the first semiconductor layer A1 and the first connection electrode NM1, for example, the first gate insulating layer 112, the first interlayer-insulating layer 113, the second interlayer-insulating layer 114, and the third interlayer-insulating layer 116. The second contact hole CNT2 may pass through the third interlayer-insulating layer 116 between the third semiconductor layer A3 and the first connection electrode NM1.

The lower metal layer BML may have a voltage level of a constant voltage. The lower metal layer BML may prevent negative charges from gathering in a lower portion of the first semiconductor layer A1 of the driving transistor T1, thereby preventing or reducing afterimages caused by the negative charges.

The first organic insulating layer 121 may be formed on the first connection electrode NM1 and the node connection electrode 171. The first organic insulating layer 121 may include an organic material, such as acrylic, benzocyclobutene ("BCB"), polyimide, or hexamethyldisiloxane ("HMDSO").

A driving voltage line PL may be disposed on the first organic insulating layer 121. The second organic insulating layer 123 may be disposed on the driving voltage line PL. The driving voltage line PL may include Al, Pt, Pd, Ag, Mg, Au, Ni, Nd, Ir, Cr, Li, Ca, Ti, and/or W. In some embodiments, the driving voltage line PL may have a triple-layered structure including a Ti layer, an Al layer, and a Ti layer.

The second organic insulating layer 123 may include an organic material, such as BCB, polyimide, or HMDSO.

The display element layer DEL may be disposed on the sub-pixel circuit layer PCL. The display element layer DEL may include display elements. In an embodiment, for example, the display element layer DEL may include an organic light-emitting diode OLED. The organic light-emitting diode OLED may include a sub-pixel electrode 210, an intermediate layer 220, and an opposite electrode 230.

The sub-pixel electrode 210 of the organic light-emitting diode OLED may be formed on the second organic insulating layer 123. The intermediate layer 220 may include a low molecular weight or high molecular weight organic material. The intermediate layer 220 may include one emission layer, and a first functional layer and a second functional layer, which are below and above the one emission layer, respectively. The second functional layer may be omitted.

An edge of the sub-pixel electrode 210 may be covered by a bank layer 130, and an inner portion of the sub-pixel electrode 210 may overlap the intermediate layer 220 through an opening 130OP defined in the bank layer 130 in a plan view. While the sub-pixel electrode 210 is formed for each organic light-emitting diode OLED, the opposite electrode 230 may be formed to correspond to a plurality of organic light-emitting diodes OLED. In other words, the plurality of organic light-emitting diodes OLED may share the opposite electrode 230, and a stacked structure in which the sub-pixel electrode 210, the intermediate layer 220, and a portion of the opposite electrode 230 are stacked may correspond to an organic light-emitting diodes OLED.

An encapsulation layer 300 may be disposed on the organic light-emitting diode OLED. The encapsulation layer 300 may include at least one inorganic encapsulation layer and at least one organic encapsulation layer. FIG. 9 shows that the encapsulation layer 300 includes a first inorganic encapsulation layer 310, an organic encapsulation layer 320, and a second inorganic encapsulation layer 330, as an example. The first inorganic encapsulation layer 310 and the second inorganic encapsulation layer 330 may include silicon oxide, silicon nitride, and/or silicon oxynitride, and the organic encapsulation layer 320 may include an organic insulating material.

Referring to a cross-section taken along line B-B' of FIG. 9, at least some of the inorganic insulating layers IIL disposed on the substrate 100 may have a groove GR provided between adjacent sub-pixel areas SPA.

The groove GR may pass through at least one selected from among the inorganic insulating layers IIL on the substrate 100, for example, the buffer layer 111, the first gate insulating layer 112, the first interlayer-insulating layer 113, the second interlayer-insulating layer 114, the second gate insulating layer 115, and the third interlayer-insulating layer 116. The depth of the groove GR may be equal to or less than the sum of the thicknesses of the buffer layer 111, the first gate insulating layer 112, the first interlayer-insulating layer 113, the second interlayer-insulating layer 114, the second gate insulating layer 115, and the third interlayer-insulating layer 116. In this regard, FIG. 9 shows that the groove GR passes through the second interlayer-insulating layer 114 and the third interlayer-insulating layer 116. The groove GR may be formed by forming openings 114a and 116a in the second interlayer-insulating layer 114 and the third interlayer-insulating layer 116, respectively. The depth of the groove GR may be equal to the sum of the thicknesses of the second gate insulating layer 115 and the third interlayer-insulating layer 116.

An organic material layer 140 may be disposed in the groove GR to fill at least a portion of the groove GR. The organic material layer 140 filling the groove GR may further reduce the influence of external impact applied to the display apparatus. The organic material layer 140 having low hardness may absorb stress caused by an external impact, thereby preventing stress from being concentrated on the inorganic insulating layer IIL and surrounding wiring lines.

The organic material layer 140 filling the groove GR may include an organic insulating material that does not overlap transistors included in the sub-pixel circuit in a plan view. The organic material layer 140 may include, for example, an organic material, such as acrylic, BCB, polyimide, or HMDSO.

In an embodiment, the organic material layer 140 may be formed to fill the inside of the groove GR and extend to the upper surface of the inorganic insulating layer IIL. A planar width GRW of the groove GR may be less than the maximum width of the organic material layer 140 filling the groove GR. The widths are measured in the plane defined by the x direction and the y direction.

In this case, an upper portion of the organic material layer 140 may have a convex shape, and for example, the upper surface of the organic material layer 140 may have a step with respect to the upper surface of the inorganic insulating layer IIL. In other words, a vertical distance h from the upper surface of the substrate 100 to the upper surface of the organic material layer 140 may be greater than a vertical distance d from the upper surface of the substrate 100 to the upper surface of the inorganic insulating layer IIL (e.g., the third interlayer-insulating layer 116) in the z direction.

FIG. 9 shows that the upper portion of the organic material layer 140 has a flat upper surface and an inclined side surface extending from the flat upper surface to the upper surface of the inorganic insulating layer IIL. However, the disclosure is not limited thereto. In another embodiment, the upper portion of the organic material layer 140 may have a curved upper surface in which an upper surface and a side surface are not clearly distinguished from each other. In this case, the vertical distance h from the upper surface of the substrate 100 to the upper surface of the organic material layer 140 may refer to the greatest vertical distance from the upper surface of the substrate 100 to the upper surface of the organic material layer 140.

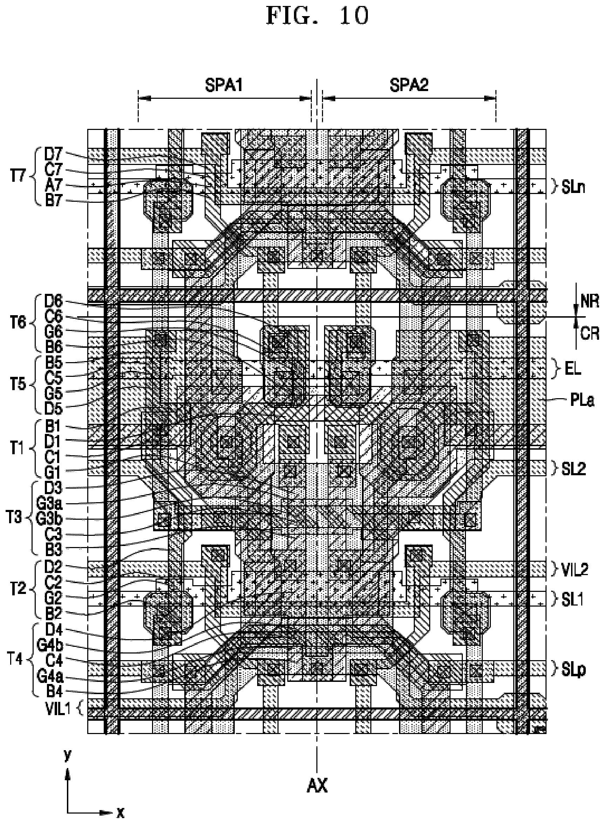

FIG. 10 is a schematic layout view of two adjacent sub-pixel circuits of a display apparatus according to an embodiment. FIG. 10 shows a portion of FIG. 3A, and shows sub-pixel circuits disposed in a first sub-pixel area SPA1 and a second sub-pixel area SPA2, which are arranged in the same row and adjacent to each other. A groove GR may be defined to surround the first sub-pixel area SPA1 and the second sub-pixel area SPA2.

The sub-pixel circuit of the first sub-pixel area SPA1 and the sub-pixel circuit of the second sub-pixel area SPA2 may be left-right symmetrical with respect to an imaginary line AX between the first sub-pixel area SPA1 and the second sub-pixel area SPA2.

Referring to FIG. 10, each of the sub-pixel circuits may include thin-film transistors and capacitors. In an embodiment, each of the sub-pixel circuits may include a driving transistor T1, a switching transistor T2, a compensation transistor T3, a first initialization transistor T4, an operation control transistor T5, an emission control transistor T6, a second initialization transistor T7, a first capacitor Cst, and a second capacitor Cbt. In an embodiment, the driving transistor T1, the switching transistor T2, the operation control transistor T5, the emission control transistor T6, and the second initialization transistor T7 may each include a thin-film transistor including a silicon semiconductor, and the compensation transistor T3 and the first initialization transistor T4 may each include a thin-film transistor including an oxide semiconductor.

Each of the sub-pixel circuits may be connected to a plurality of signal lines, a driving voltage line PL, a first initialization voltage line VIL1, and a second initialization voltage line VIL2, which extend in a first direction (e.g., an x direction) or a second direction (e.g., a y direction) crossing the first direction. The signal lines may include a data line DL, an emission control line EL, a first scan line SL1, a second scan line SL2, a previous scan line SLp, and a subsequent scan line SLn. At least one of the signal lines, the first and second initialization voltage lines VIL1 and VIL2, and the driving voltage line PL may be shared by adjacent sub-pixel circuits.

Some of the wiring lines may include two conductive layers disposed on different layers. In an embodiment, for example, referring to FIG. 10, the second scan line SL2 may include a lower second scan line SL2a and an upper second scan line SL2b disposed on different layers from each other. The previous scan line SLp may include a lower previous scan line SLpa and an upper previous scan line SLpb disposed on different layers from each other.

The subsequent scan line SLn may be the first scan line SL1 of a next row NR. In other words, the first scan line SL1 shown in FIG. 10 may be the subsequent scan line SLn of a previous row. A second initialization transistor connected to a sub-pixel of the previous row and disposed in a sub-pixel area of a current row CR, and the second initialization transistor T7 connected to a sub-pixel of the current row CR and disposed in a sub-pixel area of the next row NR are shown together in FIG. 10.

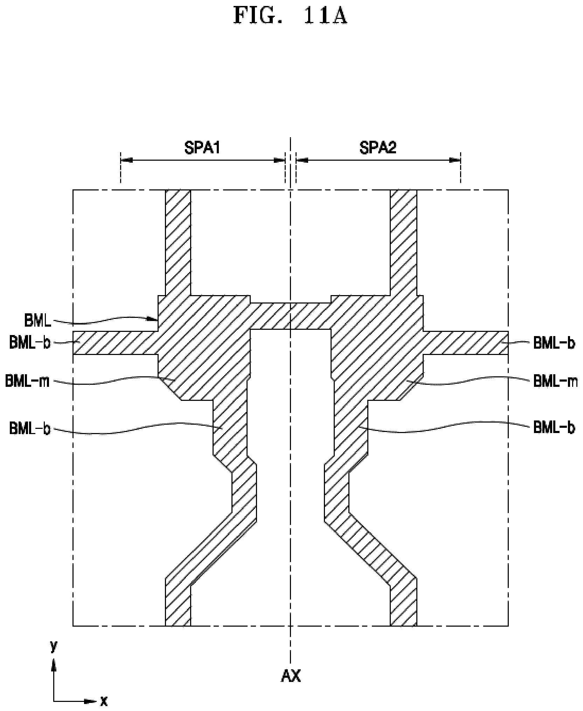

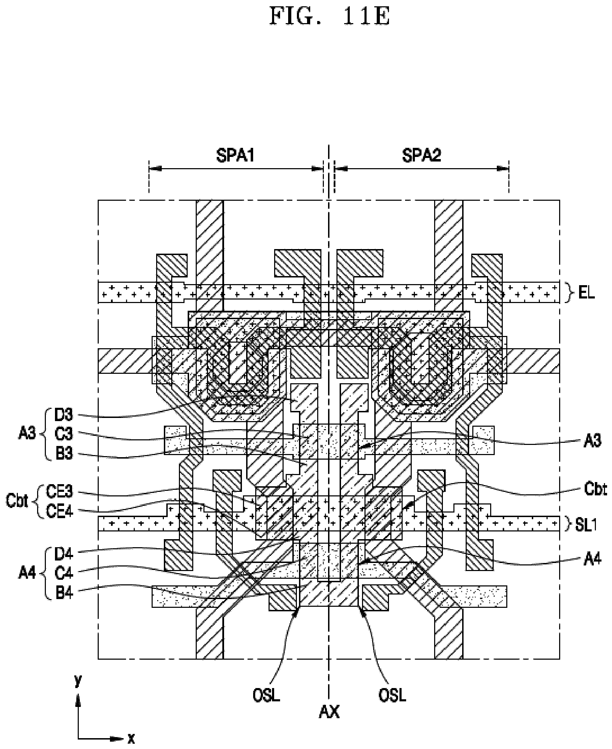

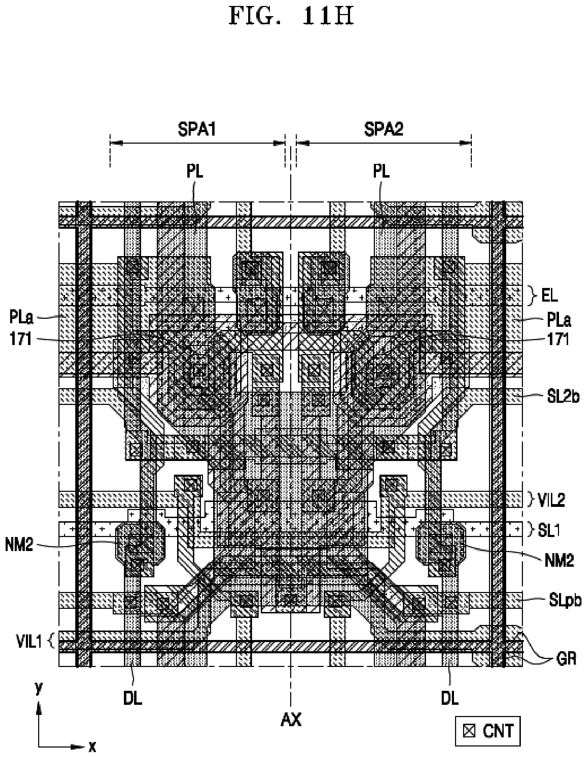

FIGS. 11A to 11H are plan views according to a process of forming components arranged in two adjacent sub-pixel areas, according to an embodiment.

Referring to FIGS. 9, 10, and 11A, a lower metal layer BML is formed on the substrate 100 (see FIG. 9). The lower metal layer BML may include the material described above with reference to FIG. 9. In an embodiment, for example, the lower metal layer BML may include a metal, such as Mo, Ti, or Al. The lower metal layer BML may be, for example, a single layer including Mo, a double layer including Mo and Ti, or a triple layer including a Ti layer, an Al layer, and a Ti layer.

As shown in FIG. 11A, the lower metal layer BML may include a portion (hereinafter, referred to as a main portion BML-m) positioned in each of the first and second sub-pixel areas SPA1 and SPA2. Each main portion BML-m may be connected to other portions (hereinafter, referred to as branch portions BML-b) extending in the x direction and the y direction.

The lower metal layer BML disposed in the first and second sub-pixel areas SPA1 and SPA2 may be substantially symmetrical with respect to an imaginary line AX between the first sub-pixel area SPA1 and the second sub-pixel area SPA2. The main portion BML-m disposed in the first sub-pixel area SPA1 and the main portion BML-m disposed in the second sub-pixel area SPA2 may be directly connected to each other.

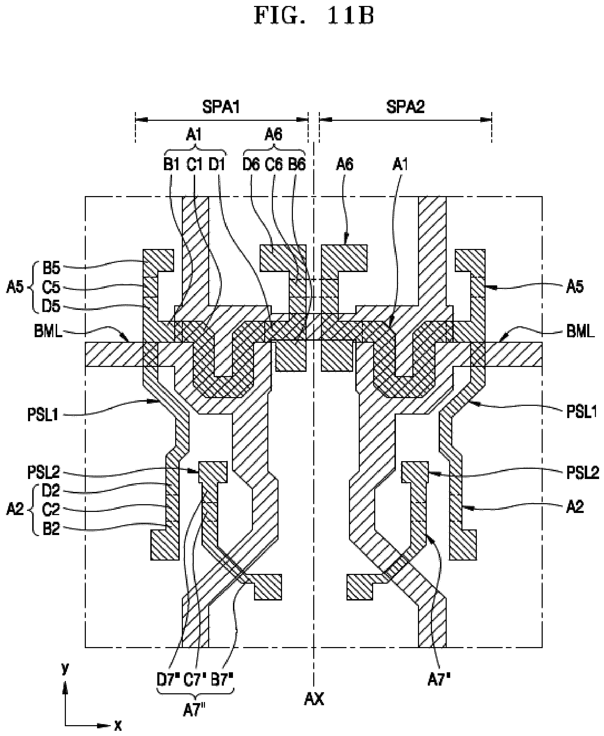

Referring to FIGS. 9, 10, and 11B, after the buffer layer 111 (see FIG. 9) is formed on the lower metal layer BML, a silicon semiconductor pattern may be formed. In this regard, FIG. 11B shows a first silicon semiconductor pattern PSL1 and a second silicon semiconductor pattern PSL2, which are disposed in each of the first sub-pixel area SPA1 and the second sub-pixel area SPA2. The first silicon semiconductor pattern PSL1 and the second silicon semiconductor pattern PSL2, disposed in the first sub-pixel area SPA1, may be substantially symmetrical with the first silicon semiconductor pattern PSL1 and the second silicon semiconductor pattern PSL2, disposed in the second sub-pixel area SPA2 with respect to the imaginary line AX. The first silicon semiconductor pattern PSL1 and the second silicon semiconductor pattern PSL2 may include a silicon-based material, such as polycrystalline silicon.

The first silicon semiconductor pattern PSL1 and the second silicon semiconductor pattern PSL2 may include the same material. In other words, a first semiconductor layer A1, a second semiconductor layer A2, a fifth semiconductor layer A5, a sixth semiconductor layer A6, and a seventh semiconductor layer A7" may include the same material. The first silicon semiconductor pattern PSL1 and the second silicon semiconductor pattern PSL2 may be apart from each other. The first silicon semiconductor pattern PSL1 may be curved in various shapes, and as shown in FIG. 11B, the first semiconductor layer A1 of the driving transistor T1, the second semiconductor layer A2 of the switching transistor T2, the fifth semiconductor layer A5 of the operation control transistor T5, and the sixth semiconductor layer A6 of the emission control transistor T6 may be arranged along the first silicon semiconductor pattern PSL1. In other words, the first silicon semiconductor pattern PSL1 may include the first semiconductor layer A1, the second semiconductor layer A2, the fifth semiconductor layer A5, and the sixth semiconductor layer A6. The first semiconductor layer A1, the second semiconductor layer A2, the fifth semiconductor layer A5, and the sixth semiconductor layer A6 may be integrally formed by being connected to each other.

The first semiconductor layer A1 includes a first channel region C1, and first and second regions B1 and D1 disposed on opposite sides of the first channel region C1, respectively. The first and second regions B1 and D1 of the first semiconductor layer A1 are impurity-doped regions and each have higher electrical conductivity than the first channel region C1. One of the first and second regions B1 and D1 may be a source region, and the other may be a drain region. The first channel region C1 may have a curved shape (e.g., an omega-shaped curved shape) in a plan view, and according to the aforementioned shape, the length of the first channel region C1 may be increased in a narrow space.

The first semiconductor layer A1 may overlap the lower metal layer BML in a plan view. In an embodiment, for example, the first channel region C1 of the first semiconductor layer A1 may overlap the lower metal layer BML in a plan view. In an embodiment, for example, the first channel region C1 of the first semiconductor layer A1 may overlap the main portion BML-m, which is a part of the lower metal layer BML in a plan view.

The second semiconductor layer A2 includes a second channel region C2, and first and second regions B2 and D2 disposed on opposite sides of the second channel region C2, respectively. The first and second regions B2 and D2 of the second semiconductor layer A2 are impurity-doped regions and each have higher electrical conductivity than the second channel region C2. One of the first and second regions B2 and D2 may be a source region, and the other may be a drain region.

The fifth semiconductor layer A5 includes a fifth channel region C5, and first and second regions B5 and D5 disposed on opposite sides of the fifth channel region C5, respectively. The first and second regions B5 and D5 of the fifth semiconductor layer A5 are impurity-doped regions and each have higher electrical conductivity than the fifth channel region C5. One of the first and second regions B5 and D5 may be a source region, and the other may be a drain region.

The sixth semiconductor layer A6 includes a sixth channel region C6, and first and second regions B6 and D6 disposed on opposite sides of the sixth channel region C6, respectively. The first and second regions B6 and D6 of the sixth semiconductor layer A6 are impurity-doped regions and each have higher electrical conductivity than the sixth channel region C6. One of the first and second regions B6 and D6 may be a source region, and the other may be a drain region.

In an embodiment, the first region B1 of the first semiconductor layer A1 may be integrally connected to the second region D2 of the second semiconductor layer A2 and the second region D5 of the fifth semiconductor layer A5, and the second region D1 of the first semiconductor layer A1 may be integrally connected to the first region B6 of the sixth semiconductor layer A6.

A seventh semiconductor layer A7" of a second initialization transistor may be formed along the second silicon semiconductor pattern PSL2. The seventh semiconductor layer A7" of the second initialization transistor disposed in each of the first and second sub-pixel areas SPA1 and SPA2 may correspond to a seventh semiconductor layer of a second initialization transistor of a sub-pixel circuit disposed in a row previous to the current row CR (see FIG. 10) in which the first and second sub-pixel areas SPA1 and SPA2 are disposed. The seventh semiconductor layer A7 (see FIG. 10) of the second initialization transistor T7 (see FIG. 10) connected to each of the sub-pixel circuits of the first and second sub-pixel areas SPA1 and SPA2 may be located in a sub-pixel area disposed in the next row NR (see FIG. 10).

The seventh semiconductor layer A7" includes a seventh channel region C7", and first and second regions B7" and D7" disposed on opposite sides of the seventh channel region C7", respectively. The first and second regions B7" and D7" of the seventh semiconductor layer A7" are impurity-doped regions and each have higher electrical conductivity than the seventh channel region C7". One of the first and second regions B7" and D7" may be a source region, and the other may be a drain region. Referring to FIGS. 9, 10, and 11C, the first gate insulating layer 112 may be formed on the first and second silicon semiconductor patterns PSL1 and PSL2, and a first gate electrode G1 of the driving transistor T1, a second gate electrode G2 of the switching transistor T2, a fifth gate electrode G5 of the operation control transistor T5, a sixth gate electrode G6 of the emission control transistor T6, and a seventh gate electrode G7" of the second initialization transistor may be disposed on the first gate insulating layer 112. A first capacitor electrode CE1, a first scan line SL1, and an emission control line EL may be disposed on the first gate insulating layer 112.

The first gate electrode G1 has an isolated shape in a plan view and may include the first capacitor electrode CE1. In other words, the first gate electrode G1 and the first capacitor electrode CE1 may be integrally formed as a single body, and it may be expressed that the first capacitor electrode CE1 includes the first gate electrode G1.

The first gate electrode G1 and/or the first capacitor electrode CE1 may be formed to entirely cover the first channel region C1 of the first semiconductor layer A1. The main portion BML-m of the lower metal layer BML may have a larger area than the first gate electrode G1 and/or the first capacitor electrode CE1. The main portion BML-m of the lower metal layer BML may entirely overlap the first channel region C1 of the first semiconductor layer A1 in a plan view.

The first gate electrode G1 and/or the first capacitor electrode CE1, disposed in the first sub-pixel area SPA1, may be substantially symmetrical with the first gate electrode G1 and/or the first capacitor electrode CE1, disposed in the second sub-pixel area SPA2, with respect to the imaginary line AX between the first sub-pixel area SPA1 and the second sub-pixel area SPA2. The first scan line SL1 disposed in the first and second sub-pixel areas SPA1 and SPA2 may be substantially symmetrical with respect to the imaginary line AX. The emission control line EL disposed in the first and second sub-pixel areas SPA1 and SPA2 may be substantially symmetrical with respect to the virtual line AX. The first scan line SL1 and the emission control line EL may each extend in the x direction to pass through the first and second sub-pixel areas SPA1 and SPA2. The first scan line SL1 and the emission control line EL may be apart from each other in a plan view with the first gate electrode G1 and/or the first capacitor electrode CE1 therebetween.

The first scan line SL1 may include a second gate electrode G2, a seventh gate electrode G7", and a third capacitor electrode CE3. The seventh gate electrode G7" disposed in each of the first and second sub-pixel areas SPA1 and SPA2 may correspond to a seventh gate electrode of a second initialization transistor of a sub-pixel circuit disposed in a row previous to the current row CR in which the first and second sub-pixel areas SPA1 and SPA2 are arranged. A portion of the first scan line SL1 may include a portion having a larger width in the y direction than other portions, and a portion having a relatively large width may correspond to the third capacitor electrode CE3. The emission control line EL may include a fifth gate electrode G5 and a sixth gate electrode G6.

The first scan line SL1 and the emission control line EL may include the same material as the first gate electrode G1 and/or the first capacitor electrode CE1, and the specific material thereof is as described above with reference to FIG. 9.

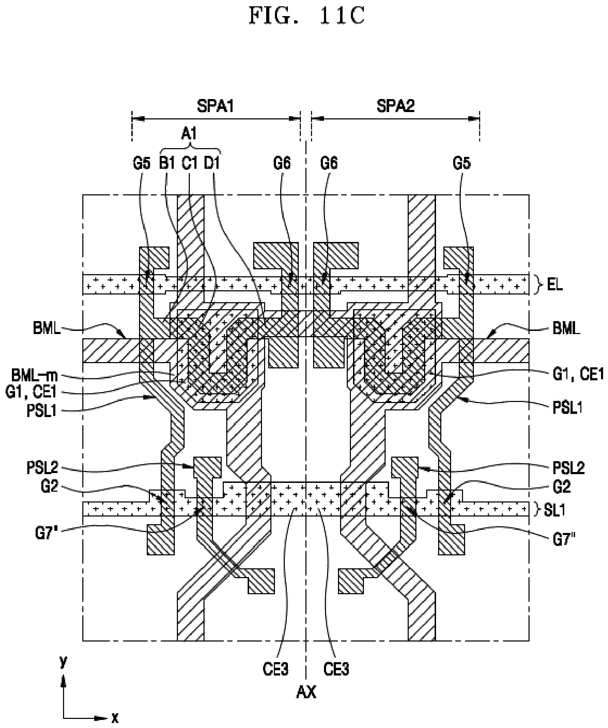

Referring to FIGS. 9, 10, and 11D, after the first interlayer-insulating layer 113 (see FIG. 9) is formed on the structure of FIG. 11C, a second capacitor electrode CE2, a third lower gate line GL3aa, and a fourth lower gate line GL4aa may be formed.

The second capacitor electrode CE2 may define a hole CE2-H therein overlapping the first capacitor electrode CE1 in a plan view and exposing a portion of the first capacitor electrode CE1. The hole CE2-H may have a structure entirely surrounded by a material portion constituting the second capacitor electrode CE2 in a plan view. In other words, the second capacitor electrode CE2 may have a donut shape in a plan view. The first capacitor electrode CE1 and the second capacitor electrode CE2 may form the first capacitor Cst. Second capacitor electrodes CE2 disposed in the first and second sub-pixel areas SPA1 and SPA2, respectively, may be integrally connected to each other.

The third lower gate line GL3aa and the fourth lower gate line GL4bb may extend in the x direction. Each of the third lower gate line GL3aa and the fourth lower gate line GL4bb disposed in the first and second sub-pixel areas SPA1 and SPA2 may have a substantially symmetrical shape with respect to the imaginary line AX.

The third lower gate line GL3aa may include a third lower gate electrode G3a, and the fourth lower gate line GL4aa may include a fourth lower gate electrode G4a.

The second capacitor electrode CE2, the third lower gate line GL3aa, and the fourth lower gate line GL4aa include the same material and are disposed on the same layer (the first interlayer-insulating layer 113 in FIG. 9). The third lower gate line GL3aa and the fourth lower gate line GL4aa may include a material that is the same as the material of the second capacitor electrode CE2 described with reference to FIG. 9.

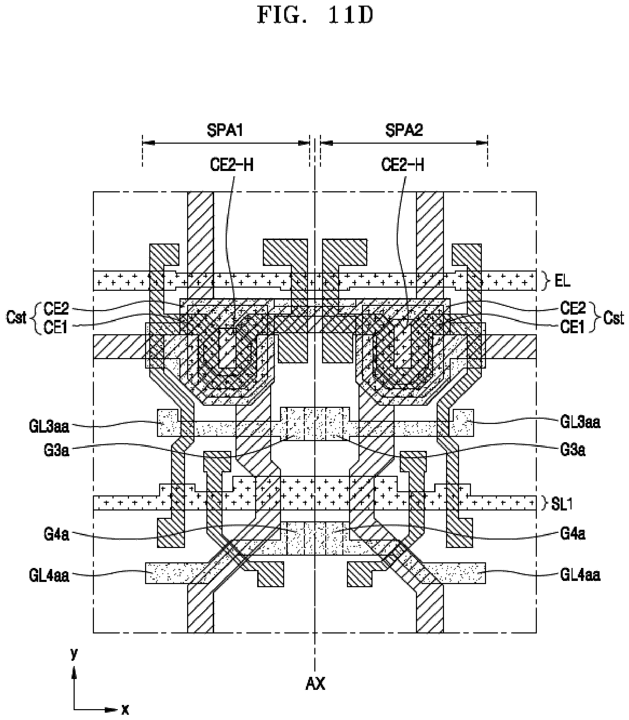

Referring to FIGS. 9, 10, and 11E, after the second interlayer-insulating layer 114 (see FIG. 9) is formed on the structure of FIG. 11D, an oxide semiconductor pattern OSL may be formed. The oxide semiconductor pattern OSL disposed in each of the first and second sub-pixel areas SPA1 and SPA2 may be symmetrical with respect to the imaginary line AX between the first pixel area SPA1 and the second sub-pixel area SPA2. Oxide semiconductor patterns OSL disposed in the first and second sub-pixel areas SPA1 and SPA2, respectively, may be connected to each other and integrally formed. The oxide semiconductor pattern OSL may include an oxide-based semiconductor material, such as Zn oxide, In-Zn oxide, or Ga-In-Zn oxide. In some embodiments, the oxide semiconductor pattern OSL may include an In-Ga-Zn-O ("IGZO") semiconductor, an In-Sn-Zn-O ("ITZO") semiconductor, or In-Ga-Sn-Zn-O ("IGTZO") semiconductor, in which metals, such as indium (In), gallium (Ga), and/or tin (Sn) are contained in ZnO,

The oxide semiconductor pattern OSL may include a third semiconductor layer A3 of the compensation transistor T3 and a fourth semiconductor layer A4 of the first initialization transistor T4. The third semiconductor layer A3 and the fourth semiconductor layer A4 may be integrally formed by being connected to each other.

The third semiconductor layer A3 includes a third channel region C3, and first and second regions B3 and D3 disposed on opposite sides of the third channel region C3, respectively. The first and second regions B3 and D3 of the third semiconductor layer A3 are conductive regions and each have higher electrical conductivity than the third channel region C3. One of the first and second regions B3 and D3 may be a source region, and the other may be a drain region.

The fourth semiconductor layer A4 includes a fourth channel region C4, and first and second regions B4 and D4 disposed on opposite sides of the fourth channel region C4, respectively. The first and second regions B4 and D4 of the fourth semiconductor layer A4 are conductive regions and each have higher electrical conductivity than the fourth channel region C4. One of the first and second regions B4 and D4 may be a source region, and the other may be a drain region.

The oxide semiconductor pattern OSL may include a fourth capacitor electrode CE4. A portion of the oxide semiconductor pattern OSL overlapping the third capacitor electrode CE3 (see FIG. 11D) in a plan view may correspond to the fourth capacitor electrode CE4. The third capacitor electrode CE3 and the fourth capacitor electrode CE4 may form the second capacitor Cbt.

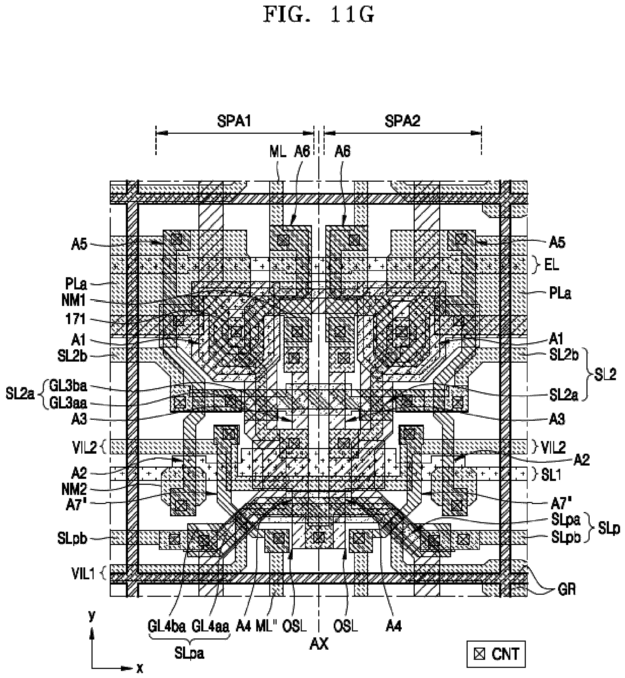

Referring to FIGS. 9, 10, and 11F, a third upper gate line GL3ba and a fourth upper gate line GL4ba may be formed on the structure of FIG. 11G.

The third lower gate line GL3aa and the fourth lower gate line GL4aa may each extend in the x direction. The third lower gate line GL3aa disposed in the first and second sub-pixel areas SPA1 and SPA2 may have a substantially symmetrical shape with respect to the imaginary line AX. The fourth lower gate line GL4aa disposed in the first and second sub-pixel areas SPA1 and SPA2 may have a substantially symmetrical shape with respect to the imaginary line AX.

At least a portion of the third upper gate line GL3ba may overlap the third lower gate line GL3aa with the oxide semiconductor pattern OSL therebetween in a plan view. The third upper gate line GL3ba includes a third upper gate electrode G3b.

At least a portion of the fourth upper gate line GL4ba may overlap the fourth lower gate line GL4aa with the oxide semiconductor pattern OSL therebetween in a plan view. The fourth upper gate line GL4ba includes a fourth upper gate electrode G4b.

The fourth upper gate electrode G4b, the third upper gate line GL3ba, and the fourth upper gate line GL4ba may include the same material as the third upper gate electrode G3b described above with reference to FIG. 9.

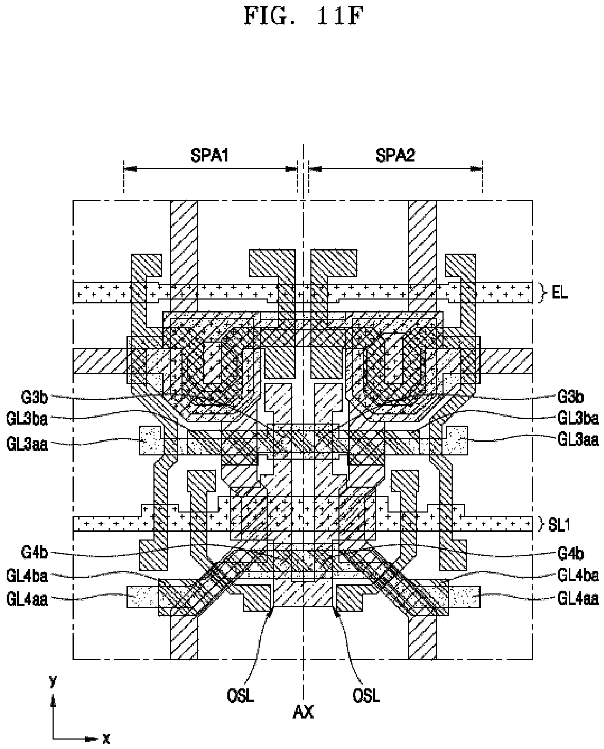

Referring to FIGS. 9, 10, and 11G, after the third interlayer-insulating layer 116 (see FIG. 9) is formed on the structure of FIG. 11F, a groove GR may be formed through, for example, an etching process. The first and second sub-pixel areas SPA1 and SPA2 may be surrounded by the groove GR in a plan view. The groove GR of FIG. 11G corresponds to the groove GR described above with reference to FIGS. 8A and 9, and may be formed by removing a portion of the inorganic insulating layers IIL (see FIG. 9). The groove GR may be filled with the organic material layer 140 (see FIG. 9). Thereafter, first and second connection electrodes NM1 and NM2, a node connection electrode 171, vertical connection lines ML and ML", an auxiliary driving voltage line PLa, an upper second scan line SL2b, an upper previous scan line SLpb, and first and second initialization voltage lines VIL1 and VIL2 may be formed. The auxiliary driving voltage line PLa, the upper second scan line SL2b, the upper previous scan line SLpb, and the first and second initialization voltage lines VIL1 and VIL2 may extend in the x direction to intersect the groove GR.

The first connection electrode NM1 may electrically connect the first semiconductor layer A1 of the first silicon semiconductor pattern PSL1 to the third semiconductor layer A3 of the oxide semiconductor pattern OSL. The first connection electrode NM1 may be connected to the second region D1 (see FIG. 10), which is a portion of the first semiconductor layer A1, through a contact hole CNT, and may be connected to the second region D3 (see FIG. 10), which is a portion of the third semiconductor layer A3, through a contact hole CNT. The second connection electrode NM2 may be connected to the first region B2 (see FIG. 10), which is a portion of the second semiconductor layer A2.

One end of the node connection electrode 171 may be connected to the first gate electrode G1 through the hole CE2-H (see FIG. 11D) of the second capacitor electrode CE2, and the other end may be connected to the third semiconductor layer A3.

The auxiliary driving voltage line PLa may be connected to the first region B5 (see FIG. 10), which is a portion of the fifth semiconductor layer A5, through a contact hole CNT, and may be electrically connected to the second capacitor electrode CE2 through a contact hole CNT.

The upper second scan line SL2b may electrically connect the third lower gate line GL3aa to the third upper gate line GL3ba by using contact holes CNT. The third lower gate line GL3aa and the third upper gate line GL3ba may form the lower second scan line SL2a. The lower second scan line SL2a and the upper second scan line SL2b may form the second scan line SL2.

The upper previous scan line SLpb may electrically connect the fourth lower gate line GL4aa to the fourth upper gate line GL4ba by using the contact holes CNT. The fourth lower gate line GL4aa and the fourth upper gate line GL4ba may form the lower previous scan line SLpa. The lower previous scan line SLpa and the upper previous scan line SLpb may form the previous scan line SLp.

The first initialization voltage line VIL1 may extend in the x direction to pass through the first and second sub-pixel areas SPA1 and SPA2. The first initialization voltage line VIL1 may be electrically connected to the first region B4 (see FIG. 10), which is a portion of the fourth semiconductor layer A4, through a contact hole CNT.

The second initialization voltage line VIL2 may extend in the x direction to pass through the first and second sub-pixel areas SPA1 and SPA2. The second initialization voltage line VIL2 may be connected to the second region D7", which is a portion of the seventh semiconductor layer A7, through a contact hole CNT.

Vertical connection lines ML and ML" may extend in the y direction and cross the groove GR. The vertical connection line ML disposed in an upper portion of each of the first and second sub-pixel areas SPA1 and SPA2 may electrically connect the sixth semiconductor layer A6 corresponding to the emission control transistor T6 to the seventh semiconductor layer A7 (see FIG. 10) of the second initialization transistor T7 (see FIG. 10) disposed in the next row NR. The vertical connection line ML" disposed in a lower portion of each of the first and second sub-pixel areas SPA1 and SPA2 may electrically connect the seventh semiconductor layer A7" disposed in each of the first and second sub-pixel areas SPA2 and SPA2 to a sixth semiconductor layer of an emission control transistor disposed in the previous row.

The first and second connection electrodes NM1 and NM2, the node connection electrode 171, the vertical connection lines ML and ML", the auxiliary driving voltage line PLa, the upper second scan line SL2b, the upper previous scan line SLpb, and the first and second initialization voltage lines VIL1 and VIL2 may include the same material. In an embodiment, for example, the second connection electrode NM2, the vertical connection lines ML and ML", the auxiliary driving voltage line PLa, the upper second scan line SL2b, the upper previous scan line SLpb, and the first and second initialization voltage lines VIL1 and VIL2 may include the same material as the first connection electrode NM1 and the node connection electrode 171 described above with reference to FIG. 9. In an embodiment, for example, the first and second connection electrodes NM1 and NM2, the node connection electrode 171, the vertical connection lines ML and ML", the auxiliary driving voltage line PLa, the upper second scan line SL2b, the upper previous scan line SLpb, and the first and second initialization voltage lines VIL1 and VIL2 may each have a triple-layered structure in which a titanium layer, an aluminum layer, and a titanium layer are stacked.

Referring to FIGS. 9, 10, and 11H, after the first organic insulating layer 121 (see FIG. 9) is formed on the structure of FIG. 11G, a data line DL and a driving voltage line PL may be formed.

The data line DL and the driving voltage line PL may extend in the y direction across the groove GR. The data line DL disposed in each of the first and second sub-pixel areas SPA1 and SPA2 may be connected to the second connection electrode NM2 through a contact hole CNT. Each data line DL may be electrically connected to the second semiconductor layer A2 of the switching transistor T2 through the second connection electrode NM2.

The driving voltage line PL may be connected to the auxiliary driving voltage line PLa through a contact hole CNT. The driving voltage line PL may be electrically connected to a portion of the fifth semiconductor layer A5 and the second capacitor electrode CE2 through the auxiliary driving voltage line PLa. Each of the second capacitor electrode CE2 and the auxiliary driving voltage line PLa extends in the x direction and thus may transmit the driving voltage ELVDD in the x direction.

The data line DL and driving voltage line PL may include Al, Pt, Pd, Ag, Mg, Au, Ni, Nd, Ir, Cr, Li, Ca, Mo, Ti, W, and/or Cu, and may include a single layer or multiple layers including the aforementioned materials. The data line DL may include the same material as the driving voltage line PL described above with reference to FIG. 9. In an embodiment, for example, the data line DL may have a structure in which a titanium layer, an aluminum layer, and a titanium layer are stacked.

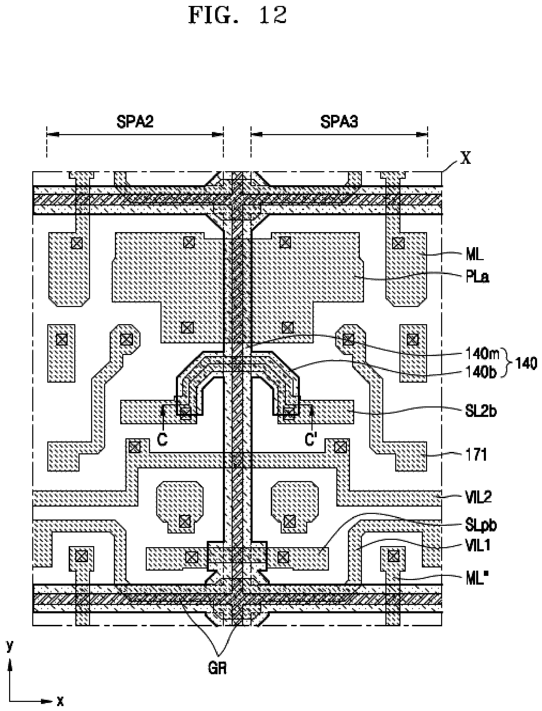

FIG. 12 is an enlarged view of a portion X of FIG. 8A, and is a plan view illustrating the groove GR and some wiring lines of the display apparatus shown in FIG. 11G.

FIG. 12 shows two adjacent sub-pixel areas SPA with the groove GR therebetween, for example, a second sub-pixel area SPA2 and a third sub-pixel area SPA3 arranged in the same row. A sub-pixel circuit disposed in the third sub-pixel area SPA3 may have the same structure as the sub-pixel circuit in the first sub-pixel area SPA1 (see FIG. 10) described above with reference to FIGS. 10 and 11A to 11H. The sub-pixel circuit disposed in the third sub-pixel area SPA3 may be left-right symmetrical with the sub-pixel circuit disposed in the second sub-pixel area SPA2 with respect to an imaginary line (not shown) between the second sub-pixel area SPA2 and the third sub-pixel area SPA3.

The groove GR of FIG. 12 corresponds to the groove GR described above with reference to FIGS. 8A and 9, and may be defined in the inorganic insulating layer IIL and may be filled by an organic material layer 140. The organic material layer 140 may include a first portion 140m and a second portion 140b. The first portion 140m of the organic material layer 140 corresponds to the organic material layer 140 described above with reference to FIG. 9, and may overlap the groove GR in a plan view and fill the inside of the groove GR.

In a plan view, the first portion 140m of the organic material layer 140 may extend in an extension direction of the groove GR. In an embodiment, the first portion 140m may be disposed to surround at least portions of the sub-pixel areas SPA. In an embodiment, for example, FIG. 12 shows that the first portion 140m of the organic material layer 140 is disposed to surround at least portions of the second sub-pixel area SPA2 and the third sub-pixel area SPA3. The width of the first portion 140m of the organic material layer 140 may be greater than a width of the groove GR.

Some wiring lines disposed on the inorganic insulating layer IIL may be disposed to cross the groove GR between adjacent sub-pixel areas SPA while passing through the adjacent sub-pixel areas SPA. In this regard, FIG. 12 shows an auxiliary driving voltage line PLa, an upper second scan line SL2b, an upper previous scan line SLpb, and first and second initialization voltage lines VIL1 and VIL2, which pass through adjacent second and third sub-pixel areas SPA2 and SP3. The auxiliary driving voltage line PLa, the upper second scan line SL2b, the upper previous scan line SLpb, and the first and second initialization voltage lines VIL1 and VIL2 may extend in the x direction and cross the groove GR defined between the adjacent second and third sub-pixel areas SPA2 and SP3.

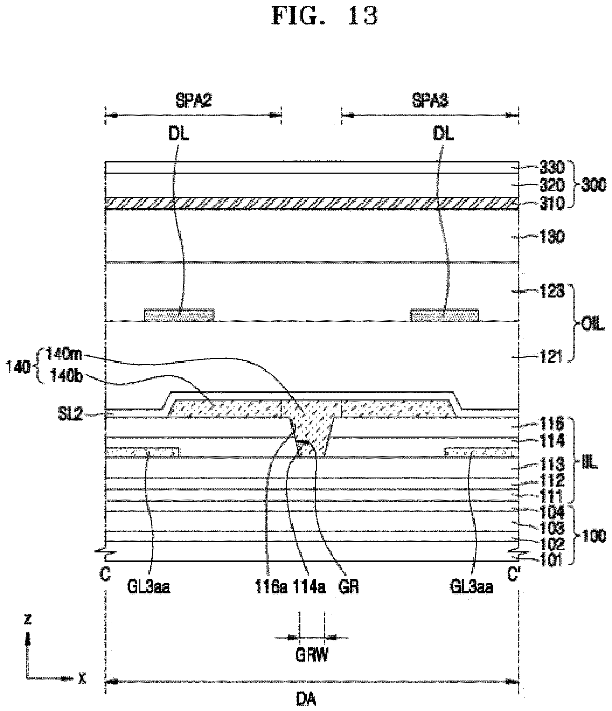

Wiring line crossing the groove GR may be defined above the organic material layer 140 in a region where there is the organic material layer 140. As will be described later with reference to FIG. 13, the wiring lines may directly contact the organic material layer 140.

In a plan view, the second portion 140b of the organic material layer 140 may be a portion extending from the first portion 140m in an extension direction of at least one wiring line among wiring lines crossing the groove GR. In this case, the second portion 140b may be disposed below the at least one wiring line. The width of the extending second portion 140b may be greater than the width of a wiring line disposed thereon.

Specifically, the second portion 140b of the organic material layer 140 may extend from the first portion 140m in an extension direction of at least one of two adjacent wiring lines among wiring lines extending in the same direction and crossing the groove GR. In this case, the second portion 140b may be disposed below at least one of the two adjacent wiring lines. In this regard, FIG. 12 shows that the second portion 140b of the organic material layer 140 extends from the first portion 140m in an extension direction of the upper second scan line SL2b among the auxiliary driving voltage line PLa and the upper second scan line SL2b adjacent to each other. In addition, it is shown that the second portions 140b of the organic material layer 140 extend from the first portion 140m in an extension direction (i.e., x direction) of each of the upper previous scan line SLpb and the first initialization voltage line VIL1 adjacent to each other.

FIG. 13 is a cross-sectional view of the display apparatus taken along line C-C' of FIG. 12.

Referring to FIG. 13, inorganic insulating layers IIL may be disposed on a substrate 100. The substrate 100 may include, for example, a first organic base layer 101, a first inorganic barrier layer 102, a second organic base layer 103, and a second inorganic barrier layer 104. The inorganic insulating layers IIL may include, for example, a buffer layer 111, a first gate insulating layer 112, a first interlayer-insulating layer 113, a second interlayer-insulating layer 114, a second gate insulating layer 115, and a third interlayer-insulating layer 116.

A groove GR may be defined in the inorganic insulating layers IIL. The groove GR may be defined through, for example, the second interlayer-insulating layer 114 and the third interlayer-insulating layer 116. The groove GR may overlap openings 114a and 116a defined in the second interlayer-insulating layer 114 and the third interlayer-insulating layer 116 in a plan view.

An organic material layer 140 may be disposed to fill at least a portion of the groove GR. The organic material layer 140 may include a first portion 140m and a second portion 140b. The first portion 140m of the organic material layer 140 may be a portion filling the inside of the groove GR and extending to the upper surface of the inorganic insulating layer IIL. The width of the first portion 140m of the organic material layer 140 may be greater than a width GRW of the groove GR. The second portion 140b of the organic material layer 140 may be a portion extending from the first portion 140m of the organic material layer 140 on the inorganic insulating layer IIL. The second portion 140b of the organic material layer 140 may extend in a direction in which a wiring line crossing the groove GR, for example, the upper second scan line SL2b, extends. The second portion 140b of the organic material layer 140 may be disposed below the upper second scan line SL2b.

The upper second scan line SL2b may be disposed on the organic material layer 140. The upper second scan line SL2b may be disposed on the inorganic insulating layer IIL (e.g., the third interlayer-insulating layer 116), but may be disposed on the organic material layer 140 in a region where the organic material layer 140 is disposed. The upper second scan line SL2b may directly contact the organic material layer 140.

A first organic insulating layer 121 may be disposed to cover the upper second scan line SL2b. Data lines DL may be disposed on the first organic insulating layer 121. A second organic insulating layer 123 may be disposed to cover the data lines DL. A bank layer 130 and an encapsulation layer 300 may be disposed on the second organic insulating layer 123. The encapsulation layer 300 may include a first inorganic encapsulation layer 310, a second inorganic encapsulation layer 330, and an organic encapsulation layer 320 between the first inorganic encapsulation layer 310 and the second inorganic encapsulation layer 330.

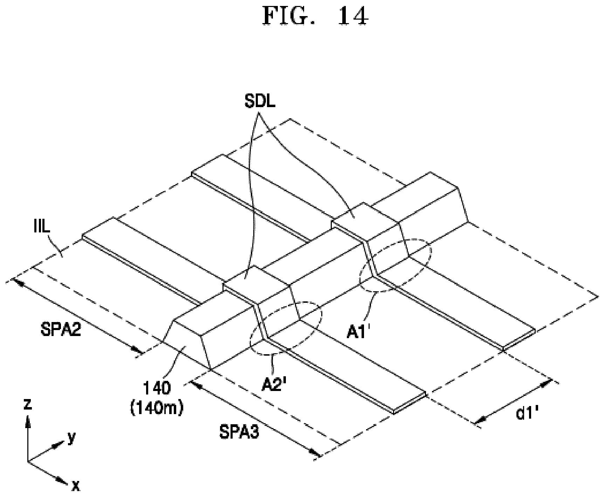

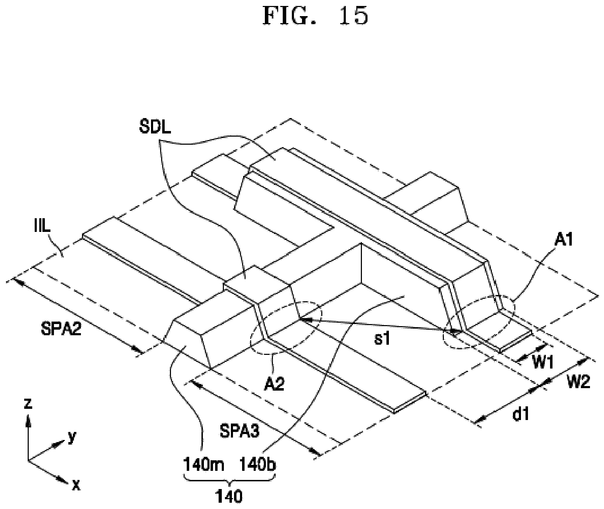

FIG. 14 is a schematic perspective view of a portion of a display apparatus according to a comparative example, and FIG. 15 is a schematic perspective view of a portion of a display apparatus according to an embodiment. FIG. 14 and FIG. 15 show part of two adjacent sub-pixel areas SPA with the groove GR therebetween, for example, the second sub-pixel area SPA2 and the third sub-pixel area SPA3 in FIG. 12.

Referring to FIGS. 14 and 15, wiring lines SDL extending in a direction (e.g., an x direction) crossing the groove GR may be disposed on the inorganic insulating layer IIL and the organic material layer 140. The inorganic insulating layer IIL may be disposed on the substrate 100 which are shown in FIG.13. In an embodiment, for example, the wiring lines SDL may correspond to the auxiliary driving voltage line PLa, the upper second scan line SL2b, the upper previous scan line SLpb, and the first and second initialization voltage lines VIL1 and VIL2, which are shown in FIG. 12.

The wiring lines SDL may be formed by a photolithography process. First, a conductive layer may be formed on the inorganic insulating layer IIL and the organic material layer 140, and a photoresist pattern may be formed to correspond to a region where the wiring lines SDL are to be formed. Then, the wiring lines SDL may be formed by removing a portion of the conductive layer by using the photoresist pattern as a mask.

In this case, in the process of forming the photoresist pattern, due to the fluidity of photoresist, a relatively thick photoresist pattern may be formed on an inclined edge region (hereinafter, referred to as "an edge region of the organic material layer 140") where the side surface (or upper surface) of the organic material layer 140 and the upper surface of the inorganic insulating layer 11L meet. When etching is performed under the same etching conditions, the width of the wiring line SDL may be greater in a portion where the photoresist pattern is formed relatively thickly than in a portion where the photoresist pattern is formed relatively thin. In a similar principle, a residual film may be formed around an edge region of the organic material layer 140 through which the wiring line SDL passes. Referring to FIG. 14, in the comparative example, when the organic material layer 140 includes only a first portion 140m crossing the groove GR, portions A1' and A2' where the wiring lines SDL meet the edge region of the organic material layer 140 may be disposed substantially on the same line in a direction (e.g., a y direction) in which the groove GR (or the first portion 140m) extends. In an embodiment, for example, a distance between the portions A1' and A2' where the wiring lines SDL meet the edge region of the organic material layer 140 may be equal to a distance d1' between the wiring lines SDL. In the case of wiring lines SDL adjacent to each other, when the widths of the wiring lines SDL are formed to be large in the portions A1' and A2' where the wiring lines SDL meet the edge region of the organic material layer 140 or a residual film is formed around the portions A1' and A2', a short may occur between the wiring lines SDL.

However, referring to FIG. 15, in an embodiment, the organic material layer 140 may include a second portion 140b extending from the first portion 140m in an extension direction of at least one of adjacent wiring lines SDL. In an embodiment, a width W2 (e.g., a width in the y direction) of the second portion 140b may be greater than a width W1 (e.g., a width in the y direction) of the wiring line SDL. In this case, the positions of the portions A1 and A2 where the wiring lines SDL meet the edge region of the organic material layer 140 may change as the organic material layer 140 (e.g., the second portion 140b of the organic material layer 140) disposed below the wiring lines SDL extends. In other words, the portions A1 and A2 where the wiring lines SDL meet the edge region of the organic material layer 140 are not located on the same line in a direction (e.g., the y direction) in which the groove GR extends, and a separation distance s1 between the portion A1 and the portion A2 may increase. In an embodiment, for example, the separation distance s1 between the portions A1 and A2 where the wiring lines SDL meet the edge region of the organic material layer 140 may be greater than the distance d1 between two wiring lines SDL. Therefore, in the present embodiment, as the organic material layer 140 includes the second portion 140b extending from the first portion 140m in an extension direction of at least one of adjacent wiring lines SDL, a margin capable of preventing a short between the adjacent wiring lines SDL may be secured even when the widths of the wiring lines SDL increase or a residual film is generated in the edge region of the organic material layer 140. Accordingly, the reliability of the display apparatus may be effectively improved.

The display apparatus according to an embodiment may be robust against external impact and may have improved reliability because a short circuit defect between adjacent wiring lines in the display apparatus is prevented. However, the scope of the disclosure is not limited by these effects.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus comprising:
a substrate (100) including a plurality of sub-pixel areas (SPA);
an inorganic insulating layer (IIL) disposing on the substrate (100) and defining a groove (GR) between two adjacent sub-pixel areas (SPA2, SPA3) from among the plurality of sub-pixel areas in a plan view;
an organic material layer (140) filled in the groove; and
a wiring line (SDL) disposed on the organic material layer (140) and passing through the two adjacent sub-pixel areas,
wherein the organic material layer (140) includes a first portion (140m) overlapping the groove in the plan view and a second portion (140b) extending from the first portion (140m) in an extension direction of the wiring line.

2. The display apparatus of claim 1, wherein the second portion (140b) of the organic material layer (140) is disposed under the wiring line (SDL).

3. The display apparatus of claim 1 or 2, wherein a width of the second portion (140b) of the organic material layer (140) is greater than a width of the wiring line (SDL).

4. The display apparatus of any of the preceding claims, wherein a vertical distance from an upper surface of the substrate (100) to an upper surface of the organic material layer (140) is greater than a vertical distance from the upper surface of the substrate (100) to an upper surface of the inorganic insulating layer (IIL).

5. The display apparatus of any of the preceding claims, wherein the wiring line (SDL) is in direct contact with the organic material layer (140).

6. The display apparatus of any of the preceding claims, wherein the groove (GR) surrounds at least some of the plurality of sub-pixel areas in the plan view.

7. The display apparatus of any of the preceding claims, wherein the groove (GR) surrounds each of the plurality of sub-pixel areas in the plan view.

8. The display apparatus of any of the preceding claims, further comprising:
a first thin-film transistor (T1) disposed in each of the plurality of sub-pixel areas and including a first semiconductor layer (A1) and a first gate electrode (G1) overlapping a channel region (C1) of the first semiconductor layer; and
an electrode overlapping and electrically connected to one of a source region and a drain region of the first semiconductor layer in the plan view.

9. The display apparatus of claim 8, further comprising a second thin-film transistor (T2) disposed in each of the plurality of sub-pixel areas and including a second semiconductor layer and a second gate electrode overlapping the second semiconductor layer,
wherein the first semiconductor layer of the first thin-film transistor includes a silicon semiconductor material, and the second semiconductor layer of the second thin-film transistor includes an oxide semiconductor material.

10. The display apparatus of claim 8 or 9, wherein the wiring line includes a same material as a material of the electrode.

11. The display apparatus of any of the preceding claim 1, wherein the display apparatus includes a display area including the plurality of sub-pixel areas,
wherein the display area is foldable or rollable.

12. The display apparatus of any of claims 8 to 11, further comprising:
a third thin-film transistor (T3) disposed in the first sub-pixel area and including a third semiconductor layer; and
a fourth thin-film transistor (T4) disposed in the second sub-pixel area and including a fourth semiconductor layer,
wherein the first semiconductor layer and the second semiconductor layer include a silicon semiconductor material, and the third semiconductor layer and the fourth semiconductor layer include an oxide semiconductor material.
